# EUROPEAN PATENT SPECIFICATION

(11) **EP 4 659 545 B1**
(45) Date of publication and mention of the grant of the patent: **12.08.2026**
(21) Application number: 24701249.5
(22) Date of filing: 25.01.2024
(51) Int. Cl.: H05B 45/20, H05B 47/17

(54) **IMPROVED QUALITY OF WHITE LIGHT WHEN SWITCHING FROM A WHITE LIGHT NON-DISINFECTION MODE TO A WHITE-VIOLET LIGHT DISINFECTION MODE**
VERBESSERTE WEISSLICHTQUALITÄT BEIM UMSCHALTEN VON EINEM WEISSLICHT-NICHTDESINFEKTIONSMODUS IN EINEN WEISSLICHT-DESINFEKTIONSMODUS
QUALITÉ AMÉLIORÉE DE LUMIÈRE BLANCHE LORS D'UNE COMMUTATION D'UN MODE DE NON-DÉSINFECTION DE LUMIÈRE BLANCHE À UN MODE DE DÉSINFECTION DE LUMIÈRE BLANCHE-VIOLETTE

(30) Priority: 31.01.2023 EP 23154192
(43) Date of publication of application: 10.12.2025
(73) Proprietor: Signify Holding B.V., 5656 AE Eindhoven (NL)
(72) Inventor: VAN BOMMEL, Ties, 5656 AE Eindhoven (NL); HIKMET, Rifat, Ata, Mustafa, 5656 AE Eindhoven (NL); ELLENS, Andries, 5656 AE Eindhoven (NL)
(74) Representative: Verweij, Petronella Daniëlle
(86) International application number: PCT/EP2024/051799
(87) International publication number: WO 2024/160652

(56) References cited:
- US-A1- 2021 068 224

## Description

### FIELD OF THE INVENTION

The invention relates to a light generating system as well as to a lighting device comprising such light generating system.

### BACKGROUND OF THE INVENTION

Antibacterial light sources are known in the art. US2020390915, for instance, describes a light source for emitting emitted light having an SPD comprising: (a) a plurality of light emitters including at least one violet solid-state emitter; (b) at least one phosphor; wherein said light emitters and said at least one phosphor being configured such that: at least 25% of the power within the SPD is in the range 390-420 nm, and the emitted light has a chromaticity which is within a Duv distance of less than 5 points from the Planckian locus.

US2021068224 disclose a lighting system having a plurality of operational modes that provide different biological effects while having good color rendering capability. The lighting systems has two or more of blue, red, short-blue-pumped cyan, long-blue-pumped, cyan, yellow, and violet channels.

### SUMMARY OF THE INVENTION

UV light has been used for disinfection for over 100 years. Wavelengths between about 190 nm and 300 nm may be strongly absorbed by nucleic acids, which may result in defects in an organism's genome. This may be desired for inactivating (killing), bacteria and viruses, but may also have undesired side effects for humans. Therefore, the selection of wavelength of radiation, intensity of radiation and duration of irradiation may be limited in environments where people may reside such as offices, public transport, cinema's, restaurants, shops, etc., thus limiting the disinfection capacity. Especially in such environments, additional measures of disinfection may be advantageous to prevent the spread of bacteria and viruses such as influenza or novel (corona) viruses like COVID-19, SARS and MERS.

It appears desirable to produce systems, which provide alternative ways for air treatment, such as disinfection. Further, existing systems for disinfection may not easily be implemented in existing infrastructure, such as in existing buildings like offices, hospitality areas, etc. and/or may not easily be able to serve larger spaces. This may again increase the risk of contamination. Further, incorporation in HVAC systems may not lead to desirable effects and appears to be relatively complex. Further, existing systems may not be efficient, or may be relatively bulky, and may also not easily be incorporated in functional devices, such as e.g. luminaires.

Other disinfection systems may use one or more anti-microbial and/or antiviral means to disinfect a space or an object. Examples of such means may be chemical agents which may raise concerns. For instance, the chemical agents may also be harmful for people and pets.

In embodiments, the disinfecting light, may especially comprise ultraviolet (UV) radiation (and/or optionally violet radiation), i.e., the light may comprise a wavelength selected from the ultraviolet wavelength range (and/or optionally the violet wavelength range). However, other wavelengths are herein not excluded. The ultraviolet wavelength range is defined as light in a wavelength range from 100 to 380 nm and can be divided into different types of UV light / UV wavelength ranges (Table 1). Different UV wavelengths of radiation may have different properties and thus may have different compatibility with human presence and may have different effects when used for disinfection (Table 1).

**Table 1: Properties of different types of UV, violet, and NIR wavelength light**

| Name | Short name | Wavelength (nm) | (Relative) sterilization effectiveness | | Safe Radiation | Vitamin D generation | Ozone generation |
|---|---|---|---|---|---|---|---|
| | | | Bacteria | Viruses | | | |
| Near Infrared (deep red) | NIR | 780-950 | + | +/- | +++ | | |
| Violet | V | 380-420 | +/- | - | + | | |
| Ultra-violet A | UV-A | 315-380 | + | - | + | | |
| Ultra-violet B | UV-B | 280-315 | + | +/- | +/- | + | |
| Near ultraviolet C | Near UV-C | 230-280 | ++ | ++ | - | | |
| Far ultra-violet C | Far UV-C | 190-230 | +++ | +++ | + | | +/- |
| Extreme ultraviolet C | Extreme UV-C | 100-190 | +++ | +++ | - | | + |

Each UV type / wavelength range may have different benefits and/or drawbacks. Relevant aspects may be (relative) sterilization effectiveness, safety (regarding radiation), and ozone production (as result of its radiation). Depending on an application a specific type of UV light or a specific combination of UV light types may be selected and provides superior performance over other types of UV light. UV-A may be (relatively) safe and may inactivate (kill) bacteria, but may be less effective in inactivating (killing) viruses. UV-B may be (relatively) safe when a low dose (i.e. low exposure time and/or low intensity) is used, may inactivate (kill) bacteria, and may be moderately effective in inactivating (killing) viruses. UV-B may also have the additional benefit that it can be used effectively in the production of vitamin D in a skin of a person or animal. Near UV-C may be relatively unsafe, but may effectively inactivating, especially kill bacteria and viruses. Far UV-C may also be effective in inactivating (killing) bacteria and viruses, but may be (relatively to other UV-C wavelength ranges) (rather) safe. Far-UV light may generate some ozone which may be harmful for human beings and animals. Extreme UV-C may also be effective in inactivating (killing) bacteria and viruses, but may be relatively unsafe. Extreme UV-C may generate ozone which may be undesired when exposed to human beings or animals. In some application ozone may be desired and may contribute to disinfection, but then its shielding from humans and animals may be desired. Hence, in the table "+" for ozone production especially implies that ozone is produced which may be useful for disinfection applications, but may be harmful for humans / animals when they are exposed to it. Hence, in many applications this "+" may actually be undesired while in others, it may be desired. The types of light indicated in above table may in embodiments be used to sanitize air and/or surfaces.

The terms "inactivating" and "killing" with respect to a virus may herein especially refer to damaging the virus in such a way that the virus can no longer infect and/or reproduce in a host cell, i.e., the virus may be (essentially) harmless after inactivation or killing.

Hence, in embodiments, the light may comprise a wavelength in the UV-A range. In further embodiments, the light may comprise a wavelength in the UV-B range. In further embodiments, the light may comprise a wavelength in the Near UV-C range. In further embodiments, the light may comprise a wavelength in the Far UV-C range. In further embodiments, the light may comprise a wavelength in the extreme UV-C range. The Near UV-C, the Far UV-C and the extreme UV-C ranges may herein also collectively be referred to as the UV-C range. Hence, in embodiments, the light may comprise a wavelength in the UV-C range. In other embodiments, the light may comprise violet radiation.

Hence, light or radiation described herein may also be indicated as disinfection light (unless otherwise indicated or clear from the context).

Using e.g. violet light may lead to a source of light that has no substantial lighting function, let alone a general lighting function. Hence, one could imagine integrating such light source in a light generating device. However, this may have undesirable impact on the spectral properties of the light. Further, it may be desirable to apply the violet light at some locations and/or during specific time periods, or as function of a sensor signal, and not to apply it when it is not necessary. Current lighting systems may not provide one or more of these function. Hence, it is an aspect of the invention to provide an alternative light generating system, which preferably further at least partly obviates one or more of above-described drawbacks. The present invention may have as object to overcome or ameliorate at least one of the disadvantages of the prior art, or to provide a useful alternative.

According to a first aspect, the invention provides a light generating system ("system") comprising a first light generating device, a second light generating device, a third light generating device, a luminescent material, and optionally a control system. **In** embodiments, the first light generating device may be configured to generate first device light, especially having a first dominant wavelength (λ1) selected from the wavelength range of 380-430 nm. **In** (further) embodiments, the second light generating device may be configured to generate second device light, especially having a second dominant wavelength (λ2) selected from the wavelength range of 430-470 nm. Yet in (further) embodiments, the third light generating device may be configured to generate third device light having a third dominant wavelength (λ3) selected from the wavelength range of 470-520 nm. Especially, in embodiments λ1< λ2< λ3. Further, in specific embodiments one or more, especially each, of the first light generating device, the second light generating device, and the third light generating device may comprise a solid state light source. Further, in embodiments the luminescent material may be configured to convert (a) at least part of the first device light received by the luminescent material into luminescent material light, (b) at least part of the second device light received by the luminescent material into luminescent material light, and (c) at least part of the third device light received by the luminescent material into luminescent material light. Especially, in embodiments the first dominant wavelength (λ1), the second dominant wavelength (λ2), the third dominant wavelength (λ3), and the luminescent material may be selected such that a second luminescent conversion (C2) of the second device light by the luminescent material is (a) higher than a first luminescent conversion (C 1) of the first device light by the luminescent material and/or (b) higher than a third luminescent conversion (C3) of the third device light by the luminescent material. Further, especially the light generating system may be configured to generate system light comprising the luminescent material light and one or more of the first device light, the second device light, the third device light. In specific embodiments, the control system may be configured to control a first radiant flux (Φ1), a second radiant flux (Φ2), and a third radiant flux (Φ3). Yet, in further specific embodiments in a first operational mode (M1) of the light generating system, the system light may comprise the second device light and the luminescent material light. Alternatively or additionally, in a second operational mode (M2) of the light generating system, the system light may comprise the first device light, the third device light, and the luminescent material light. Especially, in embodiments a ratio R1 of radiant fluxes of the device light is smaller in the first operational mode than in the second operational mode, wherein R1=(Φ1+Φ3)/(Φ2). In specific embodiments, in both operational modes, the system light may be white light. Hence, in specific embodiments the invention provides a light generating system comprising a first light generating device, a second light generating device, a third light generating device, a luminescent material, and a control system, wherein: (A) the first light generating device is configured to generate first device light having a first dominant wavelength (λ1) selected from the wavelength range of 380-430 nm; (B) the second light generating device is configured to generate second device light having a second dominant wavelength (λ2) selected from the wavelength range of 430-470 nm; (C) the third light generating device is configured to generate third device light having a third dominant wavelength (λ3) selected from the wavelength range of 470-520 nm; (E) λ1< λ2< λ3; and wherein each of the first light generating device, the second light generating device, and the third light generating device comprises a solid state light source; (F) the luminescent material is configured to convert (a) at least part of the first device light received by the luminescent material into luminescent material light, (b) at least part of the second device light received by the luminescent material into luminescent material light, and (c) at least part of the third device light received by the luminescent material into luminescent material light; (G) the first dominant wavelength (λ1), the second dominant wavelength (λ2), the third dominant wavelength (λ3), and the luminescent material are selected such that a second luminescent conversion (C2) of the second device light by the luminescent material is (a) higher than a first luminescent conversion (C1) of the first device light by the luminescent material and (b) higher than a third luminescent conversion (C3) of the third device light by the luminescent material; (H) the light generating system is configured to generate system light comprising the luminescent material light and one or more of the first device light, the second device light, the third device light; (I) the control system is configured to control a first radiant flux (Φ1), a second radiant flux (Φ2), and a third radiant flux (Φ3), wherein: (I') in a first operational mode (M1) of the light generating system, the system light comprises the second device light and the luminescent material light, and wherein especially the system light is white light; (I") in a second operational mode (M2) of the light generating system, the system light comprises the first device light, the third device light, and the luminescent material light, and wherein especially the system light is white light; and (J) in embodiments a ratio R1 of radiant fluxes of the device light is smaller in the first operational mode than in the second operational mode, wherein R1=(Φ1+Φ3)/(Φ2). In further specific embodiments the invention provides a light generating system comprising a first light generating device, a second light generating device, a third light generating device, a luminescent material, and a control system, wherein: (A) the first light generating device is configured to generate first device light having a first dominant wavelength (λ1) selected from the wavelength range of 380-430 nm; (B) the second light generating device is configured to generate second device light having a second dominant wavelength (λ2) selected from the wavelength range of 430-470 nm; (C) the third light generating device is configured to generate third device light having a third dominant wavelength (λ3) selected from the wavelength range of 470-520 nm; (E) λ1< λ2< λ3; and wherein each of the first light generating device, the second light generating device, and the third light generating device comprises a solid state light source; (F) the luminescent material is configured to convert (a) at least part of the first device light received by the luminescent material into luminescent material light, (b) at least part of the second device light received by the luminescent material into luminescent material light, and (c) at least part of the third device light received by the luminescent material into luminescent material light; (G) the first dominant wavelength (λ1), the second dominant wavelength (λ2), the third dominant wavelength (λ3), and the luminescent material are selected such that a second luminescent conversion (C2) of the second device light by the luminescent material is (a) higher than a first luminescent conversion (C1) of the first device light by the luminescent material and (b) higher than a third luminescent conversion (C3) of the third device light by the luminescent material; (H) the light generating system is configured to generate system light comprising the luminescent material light and one or more of the first device light, the second device light, the third device light; (I) the control system is configured to control a first radiant flux (Φ1), a second radiant flux (Φ2), and a third radiant flux (Φ3), wherein: (I') in a first operational mode (M1) of the light generating system, the system light comprises the second device light and the luminescent material light, and wherein especially the system light is white light; (I") in a second operational mode (M2) of the light generating system, the system light comprises (a) one or the first device light and the third device light, and (b) the luminescent material light, and wherein in further specific embodiments the system light may be white light; and (J) in embodiments a ratio R1 of radiant fluxes of the device light is smaller in the first operational mode than in the second operational mode, wherein R1=(Φ1+Φ3)/(Φ2).

With such system, it is possible to control several aspects, like (the dose i.e. the intensity and/or exposure time of) disinfection light, (the dose i.e. the intensity and/or exposure time of) melanopic light, as well as general lighting, while allowing the color point, CCT, CRI maintain essentially the same. With the present invention, a lighting system providing disinfection light and improved quality of white light for illumination is possible. Hence, with the present system light may be generated having different functionalities. Further, controlling these functionalities may in embodiments be done in combination with maintain e.g. CCT and/or radiant flux of the system light constant.

As indicated above, the invention provides a light generating system comprising a first light generating device, a second light generating device, a third light generating device, a luminescent material, and optionally a control system.

A light generating device may especially be configured to generate device light. Especially, the light generating device may comprise a light source. The light source may especially configured to generate light source light. In embodiments, the device light may essentially consist of the light source light. In other embodiments, the device light may essentially consist of converted light source light. In yet other embodiments, the device light may comprise (unconverted) light source light and converted light source light. Light source light may be converted with a luminescent material into luminescent material light and/or with an upconverter into upconverted light (see also below). The term "light generating device" may also refer to a plurality of light generating devices which may provide device light having essentially the same spectral power distributions. In (other) specific embodiments, the term "light generating device" may also refer to a plurality of light generating devices which may provide device light having different spectral power distributions.

The term "light source" may in principle relate to any light source known in the art. It may be a conventional (tungsten) light bulb, a low pressure mercury lamp, a high pressure mercury lamp, a fluorescent lamp, an LED (light emissive diode). In a specific embodiment, the light source comprises a solid state LED light source (such as an LED or laser diode (or "diode laser")). The term "light source" may also relate to a plurality of light sources, such as 2-2000 (solid state) LED light sources. Hence, the term LED may also refer to a plurality of LEDs. Further, the term "light source" may in embodiments also refer to a so-called chip-on-board (COB) light source. The term "COB" especially refers to LED chips in the form of a semiconductor chip that is neither encased nor connected but directly mounted onto a substrate, such as a PCB. Hence, a plurality of light emitting semiconductor light source may be configured on the same substrate. In embodiments, a COB is a multi LED chip configured together as a single lighting module.

The term "light source" may also refer to a chip scaled package (CSP). A CSP may comprise a single solid state die with provided thereon a luminescent material comprising layer. The term "light source" may also refer to a midpower package. A midpower package may comprise one or more solid state die(s). The die(s) may be covered by a luminescent material comprising layer. The die dimensions may be equal to or smaller than 2 mm, such as in the range of e.g. 0.2-2 mm. Hence, in embodiments the light source comprises a solid state light source. Further, in specific embodiments, the light source comprises a chip scale packaged LED. Herein, the term "light source" may also especially refer to a small solid state light source, such as having a mini size or micro size. For instance, the light sources may comprise one or more of mini LEDs and micro LEDs. Especially, in embodiment the light sources comprise micro LEDs or "microLEDs" or "µLEDs". Herein, the term mini size or mini LED especially indicates to solid state light sources having dimensions, such as die dimension, especially length and width, selected from the range of 100 µm - 1 mm. Herein, the term µ size or micro LED especially indicates to solid state light sources having dimensions, such as die dimension, especially length and width, selected from the range of 100 µm and smaller.

The light source may have a light escape surface. Referring to conventional light sources such as light bulbs or fluorescent lamps, it may be an outer surface of a glass or a quartz envelope. For LED's it may for instance be the LED die, or when a resin is applied to the LED die, the outer surface of the resin. In principle, it may also be the terminal end of a fiber. The term escape surface especially relates to that part of the light source, where the light actually leaves or escapes from the light source. The light source is configured to provide a beam of light. This beam of light (thus) escapes from the light exit surface of the light source.

Likewise, a light generating device may comprise a light escape surface, such as an end window. Further, likewise a light generating system may comprise a light escape surface, such as an end window.

The term "light source" may refer to a semiconductor light-emitting device, such as a light emitting diode (LEDs), a resonant cavity light emitting diode (RCLED), a vertical cavity laser diode (VCSELs), an edge emitting laser, etc... The term "light source" may also refer to an organic light-emitting diode (OLED), such as a passive-matrix (PMOLED) or an active-matrix (AMOLED). In a specific embodiment, the light source comprises a solid-state light source (such as an LED or laser diode). In an embodiment, the light source comprises an LED (light emitting diode). The terms "light source" or "solid state light source" may also refer to a superluminescent diode (SLED).

The term LED may also refer to a plurality of LEDs.

The term "light source" may also relate to a plurality of (essentially identical (or different)) light sources, such as 2-2000 solid state light sources. In embodiments, the light source may comprise one or more micro-optical elements (array of micro lenses) downstream of a single solid-state light source, such as an LED, or downstream of a plurality of solid-state light sources (i.e. e.g. shared by multiple LEDs). In embodiments, the light source may comprise an LED with on-chip optics. In embodiments, the light source comprises pixelated single LEDs (with or without optics) (offering in embodiments on-chip beam steering).

In embodiments, the light source may be configured to provide primary radiation, which is used as such, such as e.g. a blue light source, like a blue LED, or a green light source, such as a green LED, and a red light source, such as a red LED. Such LEDs, which may not comprise a luminescent material ("phosphor") may be indicated as direct color LEDs.

In other embodiments, however, the light source may be configured to provide primary radiation and part of the primary radiation is converted into secondary radiation. Secondary radiation may be based on conversion by a luminescent material. The secondary radiation may therefore also be indicated as luminescent material radiation. The luminescent material may in embodiments be comprised by the light source, such as an LED with a luminescent material layer or dome comprising luminescent material. Such LEDs may be indicated as phosphor converted LEDs or PC LEDs (phosphor converted LEDs). In other embodiments, the luminescent material may be configured at some distance ("remote") from the light source, such as an LED with a luminescent material layer not in physical contact with a die of the LED. Hence, in specific embodiments the light source may be a light source that during operation emits at least light at wavelength selected from the range of 380-470 nm. However, other wavelengths may also be possible. This light may partially be converted by the luminescent material.

In embodiments, the light generating device may comprise a luminescent material. In embodiments, the light generating device may comprise a PC LED. In other embodiments, the light generating device may comprise a direct LED (i.e. no phosphor). In embodiments, the light generating device may comprise a laser device, like a laser diode. In embodiments, the light generating device may comprise a superluminescent diode. Hence, in specific embodiments, the light source may be selected from the group of laser diodes and superluminescent diodes. In other embodiments, the light source may comprise an LED.

The light source may especially be configured to generate light source light having an optical axis (O), (a beam shape,) and a spectral power distribution. The light source light may in embodiments comprise one or more bands, having band widths as known for lasers.

The term "light source" may (thus) refer to a light generating element as such, like e.g. a solid state light source, or e.g. to a package of the light generating element, such as a solid state light source, and one or more of a luminescent material comprising element and (other) optics, like a lens, a collimator. A light converter element ("converter element" or "converter") may comprise a luminescent material comprising element. For instance, a solid state light source as such, like a blue LED, is a light source. A combination of a solid state light source (as light generating element) and a light converter element, such as a blue LED and a light converter element, optically coupled to the solid state light source, may also be a light source (but may also be indicated as light generating device). Hence, a white LED is a light source (but may e.g. also be indicated as (white) light generating device).

The term "light source" herein may also refer to a light source comprising a solid state light source, such as an LED or a laser diode or a superluminescent diode.

The term "light source" may (thus) in embodiments also refer to a light source that is (also) based on conversion of light, such as a light source in combination with a luminescent converter material. Hence, the term "light source" may also refer to a combination of an LED with a luminescent material configured to convert at least part of the LED radiation, or to a combination of a (diode) laser with a luminescent material configured to convert at least part of the (diode) laser radiation.

In embodiments, the term "light source" may also refer to a combination of a light source, like an LED, and an optical filter, which may change the spectral power distribution of the light generated by the light source. Especially, the term "light generating device" may be used to address a light source and further (optical components), like an optical filter and/or a beam shaping element, etc.

The phrases "different light sources" or "a plurality of different light sources", and similar phrases, may in embodiments refer to a plurality of solid-state light sources selected from at least two different bins. Likewise, the phrases "identical light sources" or "a plurality of same light sources", and similar phrases, may in embodiments refer to a plurality of solid-state light sources selected from the same bin.

The term "solid state light source", or "solid state material light source", and similar terms, may especially refer to semiconductor light sources, such as a light emitting diode (LED), a laser diode, or a superluminescent diode.

In embodiments, each of the first light generating device, the second light generating device, and the third light generating device may comprises a solid state light source. In specific embodiments, the device light of the light generating devices may essentially consist of the light source light of the respective light sources. Especially, the light generating devices are LEDs.

In embodiments, the first light generating device may be configured to generate first device light having a first dominant wavelength (λ1) selected from the wavelength range of 380-430 nm. Hence, the first device light may especially comprise violet light, or be violet light. Especially, the first light generating device may be a LED.

The term "dominant wavelength" may refer to the wavelength of the monochromatic stimulus that, when additively mixed in suitable proportions with the specified achromatic stimulus, matches the color stimulus considered.

Further, in embodiments the second light generating device may be configured to generate second device light having a second dominant wavelength (λ2) selected from the wavelength range of 430-470 nm. Hence, especially the second device light may comprise blue light, or be blue light. Further, especially the second light generating device may be a LED.

Yet further in embodiments, the third light generating device may be configured to generate third device light having a third dominant wavelength (λ3) selected from the wavelength range of 470-520 nm. Hence, especially the third device light may comprise cyan light, or be cyan light. Further, especially the third light generating device may be a LED.

In specific embodiments, λ1< λ2< λ3. More especially, in embodiments (λ1 + 5 nm) ≤ λ2 ≤ (λ3 - 5 nm). Hence, in embodiments the first dominant wavelength (λ1), the second dominant wavelength (λ2) and the third dominant wavelength (λ3) mutually differ at least 5 nm. Especially, in embodiments the first dominant wavelength (λ1); the second dominant wavelength (λ2) and the third dominant wavelength (λ3) mutually differ at least 10 Nm. More especially, in embodiments at least two of the first dominant wavelength (λ1); the second dominant wavelength (λ2), and the third dominant wavelength (λ3) mutually differ at least 15 nm, such as all three mutually differ at least 15 nm.

As indicated above, the system may comprise a luminescent material. The term "luminescent material" especially refers to a material that can convert first radiation, especially one or more of UV radiation and blue radiation, into second radiation. In general, the first radiation and second radiation have different spectral power distributions. Hence, instead of the term "luminescent material", also the terms "luminescent converter" or "converter" may be applied. In general, the second radiation has a spectral power distribution at larger wavelengths than the first radiation, which is the case in the so-called downconversion. In specific embodiments, however the second radiation has a spectral power distribution with intensity at smaller wavelengths than the first radiation, which is the case in the so-called up-conversion.

In embodiments, the "luminescent material" may especially refer to a material that can convert radiation into e.g. visible and/or infrared light. For instance, in embodiments the luminescent material may be able to convert one or more of UV radiation and blue radiation, into visible light. The luminescent material may in specific embodiments also convert radiation into infrared radiation (IR). Hence, upon excitation with radiation, the luminescent material emits radiation. In general, the luminescent material will be a down converter, i.e. radiation of a smaller wavelength is converted into radiation with a larger wavelength (λₑₓ<λₑₘ), though in specific embodiments the luminescent material may comprise up-converter luminescent material, i.e. radiation of a larger wavelength is converted into radiation with a smaller wavelength (λₑₓ>λₑₘ).

In embodiments, the term "luminescence" may refer to phosphorescence. In embodiments, the term "luminescence" may also refer to fluorescence. Instead of the term "luminescence", also the term "emission" may be applied. Hence, the terms "first radiation" and "second radiation" may refer to excitation radiation and emission (radiation), respectively. Likewise, the term "luminescent material" may in embodiments refer to phosphorescence and/or fluorescence.

The term "luminescent material" may also refer to a plurality of different luminescent materials. Examples of possible luminescent materials are indicated below. Hence, the term "luminescent material" may in specific embodiments also refer to a luminescent material composition. Instead of the term "luminescent material" also the term "phosphor" may be applied. These terms are known to the person skilled in the art.

In embodiments, luminescent materials are selected from garnets and nitrides, especially doped with trivalent cerium or divalent europium, respectively. The term "nitride" may also refer to oxynitride or nitridosilicate, etc. Alternatively or additionally, the luminescent material(s) may be selected from silicates, especially doped with divalent europium.

In specific embodiments the luminescent material comprises a luminescent material of the type A₃B₅O₁₂:Ce, wherein A in embodiments comprises one or more of Y, La, Gd, Tb and Lu, especially (at least) one or more of Y, Gd, Tb and Lu, and wherein B in embodiments comprises one or more of Al, Ga, In and Sc. Especially, A may comprise one or more of Y, Gd and Lu, such as especially one or more of Y and Lu. Especially, B may comprise one or more of Al and Ga, more especially at least Al, such as essentially entirely Al. Hence, especially suitable luminescent materials are cerium comprising garnet materials. Embodiments of garnets especially include A₃B₅O₁₂ garnets, wherein A comprises at least yttrium or lutetium and wherein B comprises at least aluminum. Such garnets may be doped with cerium (Ce), with praseodymium (Pr) or a combination of cerium and praseodymium; especially however with Ce. Especially, B may comprise aluminum (Al); however, in addition to aluminum, B may also partly comprise gallium (Ga) and/or scandium (Sc) and/or indium (In), especially up to about 20% of B, more especially up to about 10 % of B (i.e. the B ions essentially consist of 90 or more mole % of Al and 10 or less mole % of one or more of Ga, Sc and In); B may especially comprise up to about 10% gallium. In another variant, B and O may at least partly be replaced by Si and N. The element A may especially be selected from the group consisting of yttrium (Y), gadolinium (Gd), terbium (Tb) and lutetium (Lu). Further, Gd and/or Tb are especially only present up to an amount of about 20% of A. In a specific embodiment, the garnet luminescent material comprises (Y₁₋ₓLuₓ)₃B₅O₁₂:Ce, wherein x is equal to or larger than 0 and equal to or smaller than 1. The term ":Ce", indicates that part of the metal ions (i.e. in the garnets: part of the "A" ions) in the luminescent material is replaced by Ce. For instance, in the case of (Y₁₋ₓLuₓ)₃Al₅O₁₂:Ce, part of Y and/or Lu is replaced by Ce. This is known to the person skilled in the art. Ce will replace A in general for not more than 10%; in general, the Ce concentration will be in the range of 0.1 to 4%, especially 0.1 to 2% (relative to A). Assuming 1% Ce and 10% Y, the full correct formula could be (Y_{0.1}Lu_{0.89}Ce_{0.01})₃Al₅O₁₂. Ce in garnets is substantially or only in the trivalent state, as is known to the person skilled in the art.

In embodiments, the luminescent material (thus) comprises A₃B₅O₁₂ wherein in specific embodiments at maximum 10% of B-O may be replaced by Si-N.

In specific embodiments the luminescent material comprises (Yₓ₁A'ₓ₂Ceₓ₃)₃(Al_{y1}B'_{y2})₅O₁₂, wherein x1+x2+x3=1, wherein x3>0, wherein 0<x2+x3≤0.2, wherein y1+y2=1, wherein especially 0≤y2≤0.2, wherein A' comprises one or more elements selected from the group consisting of lanthanides, and wherein B' comprises one or more elements selected from the group consisting of Ga, In and Sc. In embodiments, x3 is selected from the range of 0.001-0.1. In the present invention, especially x1>0, such as >0.2, like at least 0.8. Garnets with Y may provide suitable spectral power distributions.

In specific embodiments at maximum 10% of B-O may be replaced by Si-N. Here, B in B-O refers to one or more of Al, Ga, In and Sc (and O refers to oxygen); in specific embodiments B-O may refer to Al-O. As indicated above, in specific embodiments x3 may be selected from the range of 0.001-0.04. Especially, such luminescent materials may have a suitable spectral distribution (see however below), have a relatively high efficiency, have a relatively high thermal stability, and allow a high CRI (optionally in combination with (the) light of other sources of light as described herein). Hence, in specific embodiments A may be selected from the group consisting of Lu and Gd. Alternatively or additionally, B may comprise Ga. Hence, in embodiments the luminescent material comprises (Yₓ₁(Lu,Gd)ₓ₂Ceₓ₃)₃(Al_{y1}Ga_{y2})₅O₁₂, wherein Lu and/or Gd may be available. Even more especially, x3 is selected from the range of 0.001-0.1, wherein 0<x2+x3≤0.1, and wherein 0≤y2≤0.1. Further, in specific embodiments, at maximum 1% of B-O may be replaced by SiN. Here, the percentage refers to moles (as known in the art); see e.g. also EP3149108. In yet further specific embodiments, the luminescent material comprises (Yₓ₁Ceₓ₃)₃Al₅O₁₂, wherein x1+x3=1, and wherein 0<x3≤0.2, such as 0.001-0.1.

In specific embodiments, the light generating device may only include luminescent materials selected from the type of cerium comprising garnets. In even further specific embodiments, the light generating device includes a single type of luminescent materials, such as (Yₓ₁A'ₓ₂Ceₓ₃)₃(Al_{y1}B'_{y2})₅O₁₂. Hence, in specific embodiments the light generating device comprises luminescent material, wherein at least 85 weight%, even more especially at least about 90 wt.%, such as yet even more especially at least about 95 weight % of the luminescent material comprises (Yₓ₁A'ₓ₂Ceₓ₃)₃(Al_{y1}B'_{y2})₅O₁₂. Here, wherein A' comprises one or more elements selected from the group consisting of lanthanides, and wherein B' comprises one or more elements selected from the group consisting of Ga, In and Sc, wherein x1+x2+x3=1, wherein x3>0, wherein 0<x2+x3≤0.2, wherein y1+y2=1, wherein 0≤y2≤0.2. Especially, x3 is selected from the range of 0.001-0.1. Note that in embodiments x2=0. Alternatively or additionally, in embodiments y2=0.

In specific embodiments, A may especially comprise at least Y, and B may especially comprise at least Al.

Alternatively or additionally, the luminescent material may comprise a luminescent material of the type A₃Si₆N₁₁:Ce³⁺, wherein A comprises one or more of Y, La, Gd, Tb and Lu, such as in embodiments one or more of La and Y.

In embodiments, the luminescent material may alternatively or additionally comprise one or more of MS:Eu²⁺ and/or M₂Si₅N₈:Eu²⁺ and/or MAlSiN₃:Eu²⁺ and/or Ca₂AlSi₃O₂N₅:Eu²⁺, etc., wherein M comprises one or more of Ba, Sr and Ca, especially in embodiments at least Sr. Hence, in embodiments, the luminescent may comprise one or more materials selected from the group consisting of (Ba,Sr,Ca)S:Eu, (Ba,Sr,Ca)AlSiN₃:Eu and (Ba,Sr,Ca)₂Si₅N₈:Eu. In these compounds, europium (Eu) is substantially or only divalent, and replaces one or more of the indicated divalent cations. In general, Eu will not be present in amounts larger than 10% of the cation; its presence will especially be in the range of about 0.5 to 10%, more especially in the range of about 0.5 to 5% relative to the cation(s) it replaces. The term ":Eu", indicates that part of the metal ions is replaced by Eu (in these examples by Eu²⁺). For instance, assuming 2% Eu in CaAlSiN₃:Eu, the correct formula could be (Ca_{0.98}Eu_{0.02})AlSiN₃. Divalent europium will in general replace divalent cations, such as the above divalent alkaline earth cations, especially Ca, Sr or Ba. The material (Ba,Sr,Ca)S:Eu can also be indicated as MS:Eu, wherein M is one or more elements selected from the group consisting of barium (Ba), strontium (Sr) and calcium (Ca); especially, M comprises in this compound calcium or strontium, or calcium and strontium, more especially calcium. Here, Eu is introduced and replaces at least part of M (i.e. one or more of Ba, Sr, and Ca). Further, the material (Ba,Sr,Ca)₂Si₅N₈:Eu can also be indicated as M₂Si₅N₈:Eu, wherein M is one or more elements selected from the group consisting of barium (Ba), strontium (Sr) and calcium (Ca); especially, M comprises in this compound Sr and/or Ba. In a further specific embodiment, M consists of Sr and/or Ba (not taking into account the presence of Eu), especially 50 to 100%, more especially 50 to 90% Ba and 50 to 0%, especially 50 to 10% Sr, such as Ba_{1.5}Sr_{0.5}Si₅N₈:Eu (i.e. 75 % Ba; 25% Sr). Here, Eu is introduced and replaces at least part of M, i.e. one or more of Ba, Sr, and Ca). Likewise, the material (Ba,Sr,Ca)AlSiN₃:Eu can also be indicated as MAlSiN₃:Eu, wherein M is one or more elements selected from the group consisting of barium (Ba), strontium (Sr) and calcium (Ca); especially, M comprises in this compound calcium or strontium, or calcium and strontium, more especially calcium. Here, Eu is introduced and replaces at least part of M (i.e. one or more of Ba, Sr, and Ca). Eu in the above indicated luminescent materials is substantially or only in the divalent state, as is known to the person skilled in the art.

In embodiments, a red luminescent material may comprise one or more materials selected from the group consisting of (Ba,Sr,Ca)S:Eu, (Ba,Sr,Ca)AlSiN₃:Eu and (Ba,Sr,Ca)₂Si₅N₈:Eu. In these compounds, europium (Eu) is substantially or only divalent, and replaces one or more of the indicated divalent cations. In general, Eu will not be present in amounts larger than 10% of the cation; its presence will especially be in the range of about 0.5 to 10%, more especially in the range of about 0.5 to 5% relative to the cation(s) it replaces. The term ":Eu", indicates that part of the metal ions is replaced by Eu (in these examples by Eu²⁺). For instance, assuming 2% Eu in CaAlSiN₃:Eu, the correct formula could be (Ca_{0.98}Eu_{0.02})AlSiN₃. Divalent europium will in general replace divalent cations, such as the above divalent alkaline earth cations, especially Ca, Sr or Ba.

The material (Ba,Sr,Ca)S:Eu can also be indicated as MS:Eu, wherein M is one or more elements selected from the group consisting of barium (Ba), strontium (Sr) and calcium (Ca); especially, M comprises in this compound calcium or strontium, or calcium and strontium, more especially calcium. Here, Eu is introduced and replaces at least part of M (i.e. one or more of Ba, Sr, and Ca).

Further, the material (Ba,Sr,Ca)₂Si₅N₈:Eu can also be indicated as M₂Si₅N₈:Eu, wherein M is one or more elements selected from the group consisting of barium (Ba), strontium (Sr) and calcium (Ca); especially, M comprises in this compound Sr and/or Ba. In a further specific embodiment, M consists of Sr and/or Ba (not taking into account the presence of Eu), especially 50 to 100%, more especially 50 to 90% Ba and 50 to 0%, especially 50 to 10% Sr, such as Ba_{1.5}Sr_{0.5}Si₅N₈:Eu (i.e. 75 % Ba; 25% Sr). Here, Eu is introduced and replaces at least part of M, i.e. one or more of Ba, Sr, and Ca).

Likewise, the material (Ba,Sr,Ca)AlSiN₃:Eu can also be indicated as MAlSiN₃:Eu, wherein M is one or more elements selected from the group consisting of barium (Ba), strontium (Sr) and calcium (Ca); especially, M comprises in this compound calcium or strontium, or calcium and strontium, more especially calcium. Here, Eu is introduced and replaces at least part of M (i.e. one or more of Ba, Sr, and Ca).

Eu in the above indicated luminescent materials is substantially or only in the divalent state, as is known to the person skilled in the art.

Blue luminescent materials may comprise YSO (Y₂SiO₅:Ce³⁺), or similar compounds, or BAM (BaMgAl₁₀O₁₇:Eu²⁺), or similar compounds.

The term "luminescent material" herein especially relates to inorganic luminescent materials.

Alternatively or additionally, also other luminescent materials may be applied. For instance quantum dots and/or organic dyes may be applied and may optionally be embedded in transmissive matrices like e.g. polymers, like PMMA, or polysiloxanes, etc. etc.

Quantum dots are small crystals of semiconducting material generally having a width or diameter of only a few nanometers. When excited by incident light, a quantum dot emits light of a color determined by the size and material of the crystal. Light of a particular color can therefore be produced by adapting the size of the dots. Most known quantum dots with emission in the visible range are based on cadmium selenide (CdSe) with a shell such as cadmium sulfide (CdS) and zinc sulfide (ZnS). Cadmium free quantum dots such as indium phosphide (InP), and copper indium sulfide (CuInS₂) and/or silver indium sulfide (AgInS₂) can also be used. Quantum dots show very narrow emission band and thus they show saturated colors. Furthermore the emission color can easily be tuned by adapting the size of the quantum dots. Any type of quantum dot known in the art may be used in the present invention. However, it may be preferred for reasons of environmental safety and concern to use cadmium-free quantum dots or at least quantum dots having a very low cadmium content.

Instead of quantum dots or in addition to quantum dots, also other quantum confinement structures may be used. The term "quantum confinement structures" should, in the context of the present application, be understood as e.g. quantum wells, quantum dots, quantum rods, tripods, tetrapods, or nanowires, etcetera.

Organic phosphors can be used as well. Examples of suitable organic phosphor materials are organic luminescent materials based on perylene derivatives, for example compounds sold under the name Lumogen^{®} by BASF. Examples of suitable compounds include, but are not limited to, Lumogen^{®} Red F305, Lumogen^{®} Orange F240, Lumogen^{®} Yellow F083, and Lumogen^{®} F170.

Different luminescent materials may have different spectral power distributions of the respective luminescent material light. Alternatively or additionally, such different luminescent materials may especially have different color points (or dominant wavelengths).

As indicated above, other luminescent materials may also be possible. Hence, in specific embodiments the luminescent material is selected from the group of divalent europium containing nitrides, divalent europium containing oxynitrides, divalent europium containing silicates, cerium comprising garnets, and quantum structures. Quantum structures may e.g. comprise quantum dots or quantum rods (or other quantum type particles) (see above). Quantum structures may also comprise quantum wells. Quantum structures may also comprise photonic crystals.

As can be derived from the above, the term "different luminescent materials" may refer to luminescent materials that are different, or to two compositions, each including at least one luminescent material in common, but wherein the compositions differ. For instance, a first luminescent material comprising luminescent materials A and B, and a second luminescent material comprising only A or only B, or comprising both A and B, but in a different weight ratio. Such first luminescent material and second luminescent material may have different spectral power distributions of their respective luminescent material light.

In embodiments, the luminescent material may comprise a luminescent material of the type M'ₓM₂₋₂ₓAX₆ doped with tetravalent manganese, wherein M' comprises an alkaline earth cation, M comprises an alkaline cation, and x is in the range of 0-1, wherein A comprises a tetravalent cation, for instance comprising one or more of silicon and titanium, wherein X comprises a monovalent anion, at least comprising fluorine.

A luminescent material of the type M'ₓM₂₋₂ₓAX₆ doped with tetravalent manganese is amongst others described in WO2013121355A1, which is herein incorporated by reference. Passages from WO2013121355A1 are also copied herein.

Herein, M'ₓM₂₋₂ₓAX₆ doped with tetravalent manganese, may further also shortly be indicated as "phosphor", i.e. the phrase " phosphor comprising M'ₓM₂₋₂ₓAX₆ doped with tetravalent manganese" may in an embodiment also be read as M'ₓM₂₋₂ₓAX₆ doped with tetravalent manganese phosphor, or (tetravalent) Mn-doped M'ₓM₂₋₂ₓAX₆ phosphor, or shortly "phosphor".

Relevant alkaline cations (M) are sodium (Na), potassium (K) and rubidium (Rb). Optionally, also lithium and/or cesium may be applied. In a preferred embodiment, M comprises at least potassium. In yet another embodiment, M comprises at least rubidium. The phrase "wherein M comprises at least potassium" indicates for instance that of all M cations in a mole M'ₓM₂₋₂ₓAX₆, a fraction comprises K⁺ and an optionally remaining fraction comprises one or more other monovalent (alkaline) cations (see also below). In another preferred embodiment, M comprises at least potassium and rubidium. Optionally, the M'ₓM₂₋₂ₓAX₆ luminescent material has the hexagonal phase. In yet another embodiment, the M'ₓM₂₋₂ₓAX₆ luminescent material has the cubic phase.

Relevant alkaline earth cations (M') are magnesium (Mg), strontium (Sr), calcium (Ca) and barium (Ba), especially one or more of Sr and Ba.

In an embodiment, a combination of different alkaline cations may be applied. In yet another embodiment, a combination of different alkaline earth cations may be applied. In yet another embodiment, a combination of one or more alkaline cations and one or more alkaline earth cations may be applied. For instance, KRb_{0.5}Sr_{0.25}AX₆ might be applied. As indicated above, x may be in the range of 0-1, especially x<1. In an embodiment, x=0.

The term "tetravalent manganese" refers to Mn⁴⁺. This is a well-known luminescent ion. In the formula as indicated above, part of the tetravalent cation A (such as Si) is being replaced by manganese. Hence, M'ₓM₂₋₂ₓAX₆ doped with tetravalent manganese may also be indicated as M'ₓM₂₋₂ₓA₁₋ₘMnₘX₆. The mole percentage of manganese, i.e. the percentage it replaces the tetravalent cation A will in general be in the range of 0.1-15 %, especially 1-12 %, i.e. m is in the range of 0.001-0.15, especially in the range of 0.01-0.12.

A comprises a tetravalent cation, and preferably at least comprises silicon. A may optionally (further) comprise one or more of titanium (Ti), germanium (Ge), stannum (Sn) and zinc (Zn). Preferably, at least 80%, even more preferably at least 90%, such as at least 95% of M consists of silicon. Hence, in a specific embodiment, M'ₓM₂₋₂ₓAX₆ may also be described as M'ₓM₂₋₂ₓA_{1-m-t-g-s-zr}MnₘTiₜGe_{g}SnₛZr_{zr}X₆, wherein m and x are as indicated above, and wherein t,g,s,zr are each individually preferably in the range of 0-0.2, especially 0-0.1, even more especially 0-0.05, wherein t+g+s+zr is smaller than 1, especially equal to or smaller than 0.2, preferably in the range of 0-0.2, especially 0-0.1, even more especially 0-0.05, and wherein A is especially Si. X is preferably fluorine (F).

As indicated above, M relates to monovalent cations, but preferably at least comprises potassium and/or rubidium. Other monovalent cations that may further be comprised by M can be selected from the group consisting of lithium (Li), sodium (Na), cesium (Cs) and ammonium (NH₄⁺). In an embodiment, preferably at least 80%(i.e. 80% of all moles of the type M), even more preferably at least 90%, such as 95% of M consists of potassium and/or rubidium. Especially, in these embodiments x is thus zero.

Hence, in a specific embodiment, M'ₓM₂₋₂ₓAX₆ can also be described as (K_{1-r-l-n-c-nh} RbᵣLiₗNaₙCs_{c}(NH₄)ₙₕ)₂AX₆, wherein r is in the range of 0-1, wherein l,n,c,nh are each individually preferably in the range of 0-1, preferably 0-0.2, especially 0-0.1, even more especially 0-0.05, and wherein r+ l+n+c+nh is in the range of 0-1, especially l+n+c+nh is smaller than 1, especially equal to or smaller than 0.2, preferably in the range of 0-0.2, especially 0-0.1, even more especially 0-0.05. X is preferably fluorine (F).

As indicated above, instead of or in addition to the alkaline cation(s), also one or more alkaline earth cations may be present. Hence, in a specific embodiment, M'ₓM₂₋₂ₓAX₆ can also be described as Mg_{mg}Ca_{ca}SrₛᵣBa_{ba}(KₖRbᵣLiₗNaₙCs_{c}(NH₄)ₙₕ)₂AX₆, with k, r, l, n, c, nh each individually being in the range of 0-1, wherein mg, ca, sr, ba are each individually in the range of 0-1, and wherein mg+ca+sr+ba+k+ r+ l+n+c+nh=1. In embodiments, k=1, and the others (mg, ca, sr, ba, r, l, n, c, nh) are zero.

As indicated above, X relates to a monovalent anion, but at least comprises fluorine. Other monovalent anions that may optionally be present may be selected from the group consisting of chlorine (Cl), bromine (Br), and iodine (I). Preferably, at least 80%, even more preferably at least 90%, such as 95% of X consists of fluorine. Hence, in a specific embodiment, M'ₓM₂₋₂ₓAX₆ can also be described as M'ₓM₂₋₂ₓA(F_{1-cl-b-i}Cl_{cl}Br_{b}Iᵢ)₆, wherein cl,b,i are each individually preferably in the range of 0-0.2, especially 0-0.1, even more especially 0-0.05, and wherein cl+b+i is smaller than 1, especially equal to or smaller than 0.2, preferably in the range of 0-0.2, especially 0-0.1, even more especially 0-0.05. Especially, X essentially consists of F (fluorine).

Hence, M'ₓM₂₋₂ₓAX₆ can also be described as (K_{1-r-l-n-c-nh} RbᵣLiₗNaₙCs_{c}(NH₄)ₙₕ)₂Si_{1-m-t-g-s-zr}MnₘTiₜGe_{g}SnₛZr_{zr}(F_{1-cl-b-i}Cl_{cl}Br_{b}Iᵢ)₆, with the values for r,l,n,c,nh,m,t,g,s,zr,cl,b,i as indicated above. X is preferably fluorine (F).

Even more especially, M'ₓM₂₋₂ₓAX₆ can also be described as Mg_{mg}Ca_{ca}SrₛᵣBa_{ba}(KₖRbᵣLiₗNaₙCs_{c}(NH₄)ₙₕ)₂Si_{1-m-t-g-s-zr}MnₘTiₜGe_{g}SnₛZr_{zr}(F_{1-cl-b-i}Cl_{cl}Br_{b}Iᵢ)₆, with k, r, l, n, c, nh each individually being in the range of 0-1, wherein mg, ca, sr, ba are each individually in the range of 0-1, wherein mg+ca+sr+ba+k+ r+ l+n+c+nh=1, and with the values for m,t,g,s,zr,cl,b,i as indicated above. X is preferably fluorine (F).

In an embodiment, M'ₓM₂₋₂ₓAX₆ comprises K₂SiF₆ (indicated herein also as KSiF system). As indicated above, in another preferred embodiment, M'ₓM₂₋₂ₓAX₆ comprises KRbSiF₆ (i.e. r=0.5 and l,n,c,nh,t,g,s,zr,cl,b,i are 0) (herein also indicated as K,Rb system). As indicated above, part of silicon is replaced by manganese (i.e. the formula may also be described as K₂Si₁₋ₘMnₘF₆ or KRbSi₁₋ₘMnₘF₆, with m as indicated above, or as KRbSiF₆:Mn and K₂SiF₆:Mn, respectively). As manganese replaces part of a host lattice ion and has a specific function, it is also indicated as "dopant" or "activator". Hence, the hexafluorosilicate is doped or activated with manganese (Mn⁴⁺).

In specific embodiments, the luminescent material may comprise (K,Rb)₂SiF₆:Mn⁴⁺. Alternatively or additionally, in embodiments the third luminescent material may comprise K₂SiF₆:Mn⁴⁺. Alternatively or additionally, in embodiments the third luminescent material may comprise K₂TiF₆:Mn⁴⁺. In embodiments, the third luminescent material may comprise K₂(Si,Ti)F₆:Mn⁴⁺. As can be derived from the above, "Si,Ti" may indicate one or more of Si and Ti.

The luminescent material may also be coated, as also described in WO2013121355A1.

Especially, the luminescent material may be configured to convert (a) at least part of the first device light received by the luminescent material into luminescent material light, (b) at least part of the second device light received by the luminescent material into luminescent material light, and (c) at least part of the third device light received by the luminescent material into luminescent material light. This phrase does not imply that the first device light, the second device light, and the third device light must simultaneously irradiate the luminescent material, but indicates that when at least one of them reaches the luminescent material, the luminescent material will convert at least part of the light (received by the luminescent material) convert into the luminescent material light.

Hence, in embodiments the system light may comprise luminescent material light and second device light (in the first operational mode), and in other embodiments the system light may comprise luminescent material light, first device light and third device light (in the second operational mode). However, in other embodiments the system light may comprise luminescent material light and second device light, and optionally one or more of the first device light and second device light (in the first operational mode), and in yet other embodiments the system light may comprise luminescent material light, first device light and third device light, and optionally second device light (in the second operational mode).

The luminescent material may have excitation band in the excitation spectrum, which when device light having a wavelength in the excitation band, the luminescent material is excited, leading to the luminescent material light. Such excitation band may have a maximum. Especially, the second dominant wavelength may be closest to the excitation maximum, leading to the highest (luminescent) conversion. The first dominant wavelength and the third dominant wavelength, however, may be further away from the excitation maximum than the second dominant wavelength. Hence, the (luminescent) conversion of the first device light and the third device light may be lower than of the second device light. In specific embodiments, the first dominant wavelength (λ1), the second dominant wavelength (λ2), the third dominant wavelength (λ3), and the luminescent material are selected such that a second luminescent conversion (C2) of the second device light by the luminescent material is (a) higher than a first luminescent conversion (C1) of the first device light by the luminescent material and (b) higher than a third luminescent conversion (C3) of the third device light by the luminescent material.

The luminescent conversion (or luminescent conversion factor) is indicated with C1, C2, and C3 for the respective dominant wavelengths (λ1, λ2, λ3). The luminescent conversions C1, C2, and C3 may have ratios identical to ratios of (excitation) oscillator strengths of the luminescent material at the respective dominant wavelengths (λ1, λ2, λ3). Hence, ratios C1/C2, C3/C2, C1/C3, may be derived from an excitation spectrum of the luminescent material (measuring excitation at various wavelengths, at least including the dominant wavelengths (λ1, λ2, λ3), while monitoring the luminescent material light intensity).

Especially, the light generating system may be configured to generate system light comprising the luminescent material light and one or more of the first device light, the second device light, the third device light. More especially, the system light may comprise in embodiments the luminescent material light, and at least one of the first device light, the second device light, the third device light. Hence, the light generating system may especially be configured to generate system light comprising the luminescent material light and one or more of the first device light, the second device light, the third device light. Therefore, in embodiments the luminescent material may be configured such that the conversion is not full, but only partial. In such way, the system light may also comprise at least part of the pump light. However, in other embodiments it is also possible that part of the device light is directed to the luminescent material and part of the device light is bypassing the luminescent material. In specific embodiments, however, the luminescent material is configured downstream of the first device light, the second device light, the third device light, and essentially no device light may escape from the system without being transmitted by the luminescent material. Therefore, though the invention does not exclude the reflective mode of the luminescent material, especially the luminescent material is configured in the transmissive mode.

Partial conversion may be obtained by choosing a thickness of the luminescent material layer covering the light generating devices such that there is not full conversion, and part of the device light is transmitted through the luminescent material layer covering the light generating devices. This is known in the art.

The terms "upstream" and "downstream" relate to an arrangement of items or features relative to the propagation of the light from a light generating means (here the especially the light source), wherein relative to a first position within a beam of light from the light generating means, a second position in the beam of light closer to the light generating means is "upstream", and a third position within the beam of light further away from the light generating means is "downstream".

The luminescent material may be configured in the reflective mode or in the transmissive mode. In the transmissive mode, it may be relatively easy to have light source light admixed in the luminescent material light, which may be useful for generating the desirable spectral power distribution. In the reflective mode, thermal management may be easier, as a substantial part of the luminescent material may be in thermal contact with a thermally conductive element, like a heatsink or heat spreader. In the reflective mode, a part of the light source light may in embodiments be reflected by the luminescent material and/or a reflector and may be admixed in the luminescent material light. The reflector may be configured downstream of the luminescent material (in the reflective mode).

In the reflective mode, a dichroic reflector may be used, to promote the luminescent material light over the device light. The former may be transmitted with a higher transmission than the latter and the latter may be reflected with a higher reflection than the former.

When pump light may have a spectral power distribution that may be used for both pumping the luminescent material and admixing in the system light, several options may be chosen. In embodiments, a plurality of first light generating devices may be applied, wherein one or more are used to pump the luminescent material, and one or more other first light generating devices are configured to provide first device light that bypasses the luminescent material. Alternatively or additionally, one or more first light generating devices may be used to generate first device light of which part is directed to the luminescent material and of which another part may be configured to bypass the luminescent material. This may be done e.g. via a beam splitter.

Light may bypass the luminescent material when it is not irradiating (in transmissive or reflective mode) the luminescent material. When the light bypasses the luminescent material, it will also not be converted by the luminescent material.

The light generating system may comprise a control system or may be functionally coupled to a control system. Especially, the control system may be configured to control a first radiant flux (Φ1), a second radiant flux (Φ2), and a third radiant flux (Φ3).

Under linear operation conditions, the ratios of the transmitted device light and converted device light for each of the first device light, the second device light, and the third device light may be constants. Hence, in embodiments when pumping solely with the second device light, the system light may be white light. However, other options may also be possible. In other embodiments, one or more ratios of the radiant fluxes of the first device light and the third device light, may provide white system light. In yet other specific embodiments, when pumping solely with the first device light, the system light may be white light, and/or when pumping solely with the third device light, the system light may be white light. Note that the types of white light (especially the correlated color temperature) may differ (see also below). Hence, several embodiments may be possible, wherein especially one or more of the following may apply: (i) when pumping solely with the second device light, the system light may be white light, and (ii) one or more ratios of the radiant flux of the first device light and the third device light, may provide white system light.

Especially, in embodiments in a first operational mode (M1) of the light generating system, the system light comprises the second device light and the luminescent material light and/or in a second operational mode (M2) of the light generating system, the system light comprises the first device light, the third device light, and the luminescent material light. More especially, in a first operational mode (M1) of the light generating system, the system light comprises the second device light and the luminescent material light, wherein the system light is white light, and/or in a second operational mode (M2) of the light generating system, the system light comprises the first device light, the third device light, and the luminescent material light, wherein the system light is (also) white light.

Especially, however, the system light in the two operational modes, may have different spectral power distributions. In the first operational mode, the contribution to the spectral power distribution of the second device light may relatively be larger than the contribution of the first device light and/or the third device light. In the first operational mode, in embodiments there may even be essentially no first device light and/or the third device light. In the second operational mode, the contribution to the spectral power distribution of the first device light and/or the third device light may relatively be larger than the contribution of the second device light. In the second operational mode, in embodiments there may even be essentially no second device light.

As indicated above, the radiant flux of the first device light is indicated as the first radiant flux (Φ1), the radiant flux of the second device light is indicates as the second radiant flux (Φ2), and the radiant flux of the third device light is indicated as the third radiant flux (Φ3). These radiant fluxes, or more especially their ratios may differ between the two operational modes.

In embodiments, a ratio R1 of radiant fluxes of the device light may be smaller in the first operational mode than in the second operational mode, wherein R1=(Φ1+Φ3)/(Φ2). Hence, would the ratio R1 in the first operational mode be indicated with R11 and the ratio R1 in the second operational mode with R21, then especially R11≠R21. In embodiments, R1 in the first operational mode may be at maximum 0.9, and wherein R1 in the second operational mode may be at least 1.1. Hence, in embodiments R11/R21≤0.9, more especially R11/R21≤0.5. However, other embodiments may also be possible.

Hence, in the first operational mode, the contributions of disinfection light, if any, and melanopic light, if any, to the system light may be relatively smaller than in the second operational mode, whereas in the second operational mode, the contribution of the second device light, if any, to the system light, may be relatively smaller than in the first operational mode.

Note however that the phrase "a ratio R1 of radiant fluxes of the device light is smaller in the first operational mode than in the second operational mode, wherein R1=(Φ1+Φ3)/(Φ2)" may also include embodiments wherein in the first operational mode Φ1 is zero, or Φ3 is zero or both are zero, and may also include embodiments wherein in the second operational mode Φ2 may be zero. Therefore, the phrase "a ratio R1 of radiant fluxes of the device light is smaller in the first operational mode than in the second operational mode, wherein R1=(Φ1+Φ3)/(Φ2)", may also be read as "a ratio R1 of radiant fluxes of the device light is smaller in the first operational mode than in the second operational mode, wherein R1=(Φ1+Φ3)/(Φ2), or one or more of the following applies: (a) Φ1+Φ3 is zero in the first operational mode and Φ2 is non-zero in the first operational mode, and (b) Φ1+Φ3 is non-zero in the second operational mode and Φ2 is zero in the second operational mode.

In specific embodiments, the control system is configured to maintain a radiant flux of the system light in the operational modes. Hence, while the radiant fluxes of the first device light, second device light, and the third device light may be different in the two operational modes, they may be varied such, that the radiant flux comprising the luminescent material light and one or more of the first device light, second device light, and the third device light is the same in both operational modes. In other embodiments, however, the radiant flux of the system light may differ between the two operational modes.

As can be derived from the above, in embodiments there may be more than one first operational mode and/or more than one second operational mode.

Hence, in specific embodiments in the first operational mode the radiant flux of the second device light may be larger than the radiant fluxes of the first device light and third device light, respectively. Further, in (other) specific embodiments in the second operational mode the radiant fluxes of the first device light and the third device light, respectively, may be larger than the radiant flux of the second device light.

Therefore, in specific embodiments a first operational mode first radiant flux (Φ11) of the first device light in the first operational mode is smaller than a second operational mode first radiant flux (Φ21) of the first device light in the second operational mode. Hence, in embodiments Φ11 < Φ21.

Further, in specific embodiments a first operational mode second radiant flux (Φ12) of the second device light in the first operational mode is larger than a second operational mode second radiant flux (Φ22) of the second device light in the second operational mode, Hence, in embodiments Φ12> Φ22.

Yet further, in specific embodiments a first operational mode third radiant flux (Φ13) of the third device light in the first operational mode is smaller than a second operational mode third radiant flux (Φ23) of the third device light in the second operational mode. Hence, in embodiments Φ13< Φ23.

Hence, in specific embodiments a first operational mode first radiant flux (Φ11) of the first device light in the first operational mode may be smaller than a second operational mode first radiant flux (Φ21) of the first device light in the second operational mode. Alternatively or additionally, in embodiments a first operational mode second radiant flux (Φ12) of the second device light in the first operational mode may be larger than a second operational mode second radiant flux (Φ22) of the second device light in the second operational mode. Yet, alternatively or additionally, a first operational mode third radiant flux (Φ13) of the third device light in the first operational mode may be smaller than a second operational mode third radiant flux (Φ23) of the third device light in the second operational mode.

Note that (in embodiments) the above mentioned R11 may also be defined as (Φ11+ Φ13)/ Φ12, and R21 may also be defined as (Φ21+ Φ23)/ Φ22.

**In** specific embodiments, one or more of the following may apply: (i) the first dominant wavelength (λ1) is selected from the wavelength range of 380-420 nm, (ii) the second dominant wavelength (λ2) selected from the wavelength range of 440-460 nm; and (iii) the third dominant wavelength (λ3) selected from the wavelength range of 470-520 nm. Especially, ally may apply. More especially, in embodiments the first dominant wavelength (λ1) is selected from the wavelength range of 400-410 nm and/or the third dominant wavelength (λ3) is selected from the wavelength range of 480-490 nm. This may be beneficial in view of effectivity of the disinfection radiation and/or melanopic effects, respectively.

Further, as can be derived from the above, especially each of the first light generating device, the second light generating device, and the third light generating device may comprise a light emitting diode.

Referring to the control system and the operational modes, some embodiments are described below.

The term "controlling" and similar terms especially refer at least to determining the behavior or supervising the running of an element. Hence, herein "controlling" and similar terms may e.g. refer to imposing behavior to the element (determining the behavior or supervising the running of an element), etc., such as e.g. measuring, displaying, actuating, opening, shifting, changing temperature, etc. Beyond that, the term "controlling" and similar terms may additionally include monitoring. Hence, the term "controlling" and similar terms may include imposing behavior on an element and also imposing behavior on an element and monitoring the element. The controlling of the element can be done with a control system, which may also be indicated as "controller". The control system and the element may thus at least temporarily, or permanently, functionally be coupled. The element may comprise the control system. **In** embodiments, the control system and element may not be physically coupled. Control can be done via wired and/or wireless control. The term "control system" may also refer to a plurality of different control systems, which especially are functionally coupled, and of which e.g. one control system may be a master control system and one or more others may be slave control systems. A control system may comprise or may be functionally coupled to a user interface.

The control system may also be configured to receive and execute instructions from a remote control. **In** embodiments, the control system may be controlled via an App on a device, such as a portable device, like a Smartphone or I-phone, a tablet, etc.. The device is thus not necessarily coupled to the lighting system, but may be (temporarily) functionally coupled to the lighting system.

Hence, in embodiments the control system may (also) be configured to be controlled by an App on a remote device. In such embodiments the control system of the lighting system may be a slave control system or control in a slave mode. For instance, the lighting system may be identifiable with a code, especially a unique code for the respective lighting system. The control system of the lighting system may be configured to be controlled by an external control system which has access to the lighting system on the basis of knowledge (input by a user interface of with an optical sensor (e.g. QR code reader) of the (unique) code. The lighting system may also comprise means for communicating with other systems or devices, such as on the basis of Bluetooth, Thread, WIFI, LiFi, ZigBee, BLE or WiMAX, or another wireless technology.

The system, or apparatus, or device may execute an action in a "mode" or "operation mode" or "mode of operation" or "operational mode". The term "operational mode may also be indicated as "controlling mode". Likewise, in a method an action or stage, or step may be executed in a "mode" or "operation mode" or "mode of operation" or "operational mode". This does not exclude that the system, or apparatus, or device may also be adapted for providing another controlling mode, or a plurality of other controlling modes. Likewise, this may not exclude that before executing the mode and/or after executing the mode one or more other modes may be executed.

However, in embodiments a control system may be available, that is adapted to provide at least the controlling mode. Would other modes be available, the choice of such modes may especially be executed via a user interface, though other options, like executing a mode in dependence of a sensor signal or a (time) scheme, may also be possible. The operation mode may in embodiments also refer to a system, or apparatus, or device, which can only operate in a single operation mode (i.e. "on", without further tunability).

Hence, in embodiments, the control system may control in dependence of one or more of an input signal of a user interface, a sensor signal (of a sensor), and a timer. The term "timer" may refer to a clock and/or a predetermined time scheme.

Above, it has been indicated that in embodiments the second dominant wavelength may be closest to the excitation maximum, leading to the highest (luminescent) conversion, and the first dominant wavelength and the third dominant wavelength, however, may be further away from the excitation maximum than the second dominant wavelength. Especially, in embodiments λ2 may be chosen at ≥80% of the maximum peak excitation wavelength, λ1 may be chosen at ≤50% of the maximum peak excitation wavelength, and λ3 may be chosen at ≤50% of the maximum peak excitation wavelength. However, other locations in the excitation spectrum of the dominant wavelengths are herein not excluded.

Especially, in embodiments 0.1≤C1/C2≤0.7 and/or wherein 0.1≤C3/C2≤0.7. Further, in embodiments 0.3≤C2/C3≤0.95. As indicated above, this may be beneficial in view of effectivity of the disinfection radiation and/or melanopic effects, respectively, and may allow in the first operational mode system light that has a reduced effect in terms of disinfection and influence on the circadian rhythm.

Hence, the luminescent material may have an emission band such that e.g. (λ1 + 5 nm) ≤ λ2 ≤ (λ3 - 5 nm) can be achieved. For e.g. quantum dots, cerium comprising garnets, and divalent europium comprising nitrides, this may be the case. For determining (the conversion factors) C1, C2, and C3, it is assumed that the quantum efficiency in the wavelength range wherein the first dominant wavelength, the second dominant wavelength, and the third dominant wavelength are selected, is essentially constant. Hence, effectively, the height (value on the y-axis) in the excitation spectrum for a specific wavelength may be the conversion factor C. For this reason, the conversion factor does not necessarily include the quantum efficiency. However, the quantum efficiency could be included. Herein, especially ratios between C1, C2, and C3 are relevant, not their absolute values. As indicated above, ratios between C1, C2, and C3 may be (essentially) identical to ratios of the (excitation) oscillator strengths at the respective dominant wavelengths.

As indicated above, the luminescent material may especially be configured downstream of the first light generating device, the second light generating device, and the third light generating device. In embodiments, the luminescent material may be provided as such. In (other) embodiments, the luminescent material may be provided as coating. In (yet other) embodiments, the luminescent material may be provided as ceramic body.

In specific embodiments, the luminescent material may be comprised by a light transmissive body, such as a polymeric body, like a silicone body or PMMA body, with the luminescent material embedded therein, such as a particulate material dispersed in the polymeric material. The polymeric material as such, may be essentially transparent for the device light. Hence, in embodiments the system may comprise an encapsulant, wherein the encapsulant (at least partly) covers the first light generating device, the second light generating device, and the third light generating device; wherein the encapsulant comprises a light transmissive host material with the luminescent material embedded therein. As indicated above, the encapsulant may e.g. comprise silicone, such as PDMS (polydimethylsiloxane), or PMMA (poly(methyl methacrylate)). Other materials, however, may also be possible. In embodiments, the luminescent material may substantially enclose the light generating devices.

Above, a number of luminescent materials have been listed. In specific embodiments, the luminescent material at least comprises a first luminescent material comprising a luminescent material of the type A₃B₅O₁₂:Ce, wherein A comprises one or more of Y, La, Gd, Tb and Lu, and wherein B comprises one or more of Al, Ga, In and Sc. These garnet-type materials may have a relatively high quenching temperature and a relative high quantum efficiency. Centroid wavelengths of garnet-type luminescent materials may be in the blue-orange wavelength range (i.e. 440-620 nm, especially in the green-yellow wavelength range 490-590 nm).

The terms "violet light" or "violet emission", and similar terms, may especially relate to light having a wavelength in the range of about 380-440 nm. In specific embodiments, the violet light may have a centroid wavelength in the 380-440 nm range. The terms "blue light" or "blue emission", and similar terms, may especially relate to light having a wavelength in the range of about 440-490 nm (including some violet and cyan hues). In specific embodiments, the blue light may have a centroid wavelength in the 440-490 nm range. The terms "green light" or "green emission", and similar terms, may especially relate to light having a wavelength in the range of about 490-560 nm. In specific embodiments, the green light may have a centroid wavelength in the 490-560 nm range. The terms "yellow light" or "yellow emission", and similar terms, may especially relate to light having a wavelength in the range of about 560-590 nm. In specific embodiments, the yellow light may have a centroid wavelength in the 560-590 nm range. The terms "orange light" or "orange emission", and similar terms, may especially relate to light having a wavelength in the range of about 590-620 nm. In specific embodiments, the orange light may have a centroid wavelength in the 590-620 nm range. The terms "red light" or "red emission", and similar terms, may especially relate to light having a wavelength in the range of about 620-750 nm. In specific embodiments, the red light may have a centroid wavelength in the 620-750 nm range. The terms "cyan light" or "cyan emission", and similar terms, especially relate to light having a wavelength in the range of about 490-520 nm. In specific embodiments, the cyan light may have a centroid wavelength in the 490-520 nm range. The terms "amber light" or "amber emission", and similar terms, may especially relate to light having a wavelength in the range of about 585-605 nm, such as about 590-600 nm. In specific embodiments, the amber light may have a centroid wavelength in the 585-605 nm range. The phrase "light having one or more wavelengths in a wavelength range" and similar phrases may especially indicate that the indicated light (or radiation) has a spectral power distribution with at least intensity or intensities at these one or more wavelengths in the indicate wavelength range. For instance, a blue emitting solid state light source will have a spectral power distribution with intensities at one or more wavelengths in the 440-495 nm wavelength range.

The term "centroid wavelength", also indicated as λc, is known in the art, and refers to the wavelength value where half of the light energy is at shorter and half the energy is at longer wavelengths; the value is stated in nanometers (nm). It is the wavelength that divides the integral of a spectral power distribution into two equal parts as expressed by the formula λc = Σ λ*I(λ) / (Σ I( λ)), where the summation is over the wavelength range of interest, and I(λ) is the spectral energy density (i.e. the integration of the product of the wavelength and the intensity over the emission band normalized to the integrated intensity). The centroid wavelength may e.g. be determined at operation conditions.

One or more of such first materials may be used to generated, together with the blue pumping light, white system light. Note that the term "first luminescent material" may also relate to a plurality of first luminescent materials.

Alternative or especially in addition to the first luminescent material, a second luminescent material. Especially, in embodiments the luminescent material at least comprises a second luminescent material configured to convert at least part of the device light when received by the second luminescent material into second luminescent light having a wavelength in the orange-red wavelength range. The term "orange-red wavelength range" especially refers to the 590-780 nm wavelength range. Note that the term "second luminescent material" may also relate to a plurality of second luminescent materials.

In embodiments, the second luminescent material comprises one or more luminescent materials selected from the group of a red emitting divalent europium based nitride phosphor, a red emitting quantum structure, and a red emitting tetravalent manganese based fluoride phosphor. Especially, a combination of the first luminescent material and the second luminescent material may be applied. Also a combination of (a) one or more first luminescent materials and (b) one or more second luminescent materials. This may be useful in view of the color rendering index. A red emitting quantum structure may be a quantum structure, such a quantum dots, quantum rods, photonic structures, etc. (see also above), which may emit in the red wavelength range.

When there are two or more luminescent materials, the luminescent conversion (or luminescent conversion factor) indicated with C1, C2, and C3 for the respective dominant wavelengths (λ1, λ2, λ3), may especially apply to at least one of the luminescent materials. Especially, when two or more luminescent materials are applied, in embodiments for each of the luminescent materials may apply that its second conversion factor ("C2") is larger than its first conversion factor ("C1") and larger than its third conversion factor ("C3") . However, other embodiments may also be possible.

In embodiments, the system comprises more than three light generating devices. Hence, the system may comprise one or more first light generating devices, one or more second light generating devices, and one or more third light generating devices. In specific embodiments, the system may comprise N1 first light generating devices, N2 second light generating devices, and N3 third light generating devices, wherein N1+N2+N3≥3, such as N1+N2+N3≥3, more especially N1+N2+N3≥20. Hence, N1≥, N2≥1, and N3≥1. Yet, in further specific embodiments 0.7≤N1/N3≤1.3 and wherein N1≥3. A large number of light generating devices may provide an even luminescence. Differences between the modes may be reduces when using a large(r) number of light generating devices.

In embodiments, the system may comprise a first LED string, wherein the second light generating devices are comprised by the first LED string, and a second LED string, wherein the first light generating devices and the third light generating devices are comprised by the first LED string. In such embodiments, the control system may control the LED strings individually, and may the second light generating devices on the one hand, and the first light generating devices and the third light generating devices on the other hand be controlled as respective (two) groups.

In alternative embodiments, the system may comprise a first LED string, wherein the first light generating devices are comprised by the first LED string, a second LED string, wherein the second light generating devices are comprised by the second LED string, and a third LED string, wherein the third light generating devices are comprised by the third LED string. In such embodiments, the control system may control the LED strings individually, and may the first light generating devices, the second light generating devices, and the third light generating devices be controlled as respective (three) groups. Hence, in embodiments the control system may control two or more LED strings, wherein the light generating devices are comprises by the two or more LED strings.

In specific embodiments, the light generating devices may be comprised by a COB (chips-on-board device). Therefore, in embodiments the system may comprise a chips-on-board device, wherein the chips-on-board device comprises the first light generating device, the second light generating device, the third light generating device, and the luminescent material. The light generating devices may be supported by a support (or "carrier") comprised by the COB and the luminescent material may cover the light generating devices (and at least part of the support).

In alternative embodiments, the system may comprise a LED filament, wherein the LED filament comprises the first light generating device, the second light generating device, the third light generating device, and the luminescent material.

Especially, an LED filament may be configured to provide LED filament light. The term "LED filament light" may refer to the light of the LED filament during operation of the LED filament. The LED filament may in embodiments comprises a plurality of light emitting diodes (LEDs), especially arranged in a linear array.

The linear array may be a 1D or 2D array, of n*m LEDs, wherein n may in embodiments be selected from the range of 1-4, such as 1-3, like 1-2, such as in embodiments 1 or in embodiments 2, and m may be selected from the range of larger than n, such as especially selected from the range of at least 4 (when n<4), like at least 6, such as at least 8.

Further, the LEDs may be arranged for emitting LED light e.g. of different colors or spectral power distributions. In embodiments, two or more LEDs may be configured to provide light having essentially the same spectral power distributions. Even more especially, in embodiments all LEDs may be configured to provide light having essentially the same spectral power distributions. In yet other embodiments, two or more LEDs may be configured to provide light having different spectral power distributions.

In embodiments, the LED filament may have a length L and a width W, with in specific embodiments L≥5W. The LED filament may be arranged in a straight configuration or in a non-straight configuration, such as for example a curved configuration, a (2D or 3D) spiral, or a helix.

In specific embodiments, the LEDs may be arranged on an (elongated) carrier like for instance a substrate. In embodiments, the (elongated) carrier may be rigid (made from e.g. a polymer, glass, quartz, metal or sapphire) or flexible (e.g. made of a polymer or metal e.g. a film or foil).

In case the carrier comprises a first major surface and an opposite second major surface, the LEDs are arranged on at least one of these surfaces. In embodiments, the carrier may be light reflective, especially reflective for the filament light. In embodiments, the carrier may be light transmissive, such as translucent and in specific embodiments transparent.

In embodiments, the LED filament may comprise an encapsulant at least partly covering at least part of the total number of LEDs (of the plurality of LEDs). In specific embodiments, the encapsulant may also at least partly cover at least one of the first major or second major surface.

The encapsulant may comprise a polymer material which may in embodiments be flexible such as for example a silicone. In embodiments, the encapsulant may comprise a resin.

In embodiments, the encapsulant may comprise one or more of a luminescent material and a light scattering material. The one or more of the luminescent material and the light scattering material may be embedded in the encapsulant material, such as the polymer material. The luminescent material may especially be configured to at least partly convert LED light into converted light. The luminescent material may also be indicated as "phosphor". The luminescent material may comprise a phosphor such as an inorganic phosphor and/or quantum dots or rods.

Hence, the LED filament light may comprise in specific embodiments one or more of LED light and converted light ("luminescent material light").

In embodiments, a LED filament may comprise an elongated substrate. In embodiments, the elongated substrate may be light transmissive (for the LED light, see below). The substrate may have a first main surface at a first side of the substrate and a second main surface at a second side of the substrate, opposite to the first side. A plurality of LEDs may be mounted onto the first main surface and configured to emit LED light. An encapsulant may cover the plurality of LEDs (on the first main surface) and at least part of the first main surface, and optionally also at least part of the second main surface. Optionally, a plurality of LEDs may also be mounted onto the second main surface and be configured to emit LED light. The encapsulant may also cover the plurality of LEDs (on the second main surface) (and at least part of the second main surface). The encapsulant may comprise a luminescent material. The luminescent material may be configured to convert at least part of the LED light. The encapsulant may also transmit at least part of the (unconverted) LED light. The encapsulant may comprise a resin, like a silicone, with the luminescent material embedded therein.

In embodiments, the LED filament may comprise multiple sub-filaments.

As indicated above, the LED filament may in embodiments comprises a plurality of light emitting diodes. However, the term LED in the context of LED filament, may also refer to solid state light sources (in general). Hence, the LED filament may comprise one or more of LEDs, laser diodes, and superluminescent diodes. Especially, the LED filament comprises a plurality of light emitting diodes (LEDs).

Hence, in embodiments the light generating system may comprise a LED filament, wherein the LED filament comprises the first light generating device, the second light generating device, the third light generating device, and the luminescent material. Especially, the luminescent material may cover the light generating devices. Further, the luminescent material may also cover the carrier which supports the light generating devices. The luminescent material may also be configured on the back side of the carrier. In embodiments, the carrier may be light transmissive. Hence, in embodiments the luminescent material at the backside of the carrier may also convert part of the device light of one or more of the light generating devices. Hence, in the case of a LED filament, the luminescent material may substantially enclose the light generating devices.

As indicated above, in embodiments in the first operational mode and in the second operational mode white light may be generated. In specific embodiments, in both operational modes, the correlated color temperature and/or the color point of the system light may be essentially the same. This may allow changing the function (less or more disinfection and/or less or more alert making light) of the lighting while maintain the main function of the lighting (i.e. providing visibility) constant. Hence, in embodiments the system light in the first operational mode has a first correlated color temperature CCT1, wherein the system light in the second operational mode has a second correlated color temperature CCT2, wherein |CCT1-CCT2|≤ 1000 K, especially |CCT1-CCT2|≤ 500 K, more especially |CCT1-CCT2|≤ 300 K.

In specific embodiments, colors or color points of a first type of light and a second type of light may be essentially the same when the respective color points of the first type of light and the second type of light differ with at maximum 0.03 for u' and/or with at maximum 0.03 for v', even more especially at maximum 0.02 for u' and/or with at maximum 0.02 for v'. In yet more specific embodiments, the respective color points of first type of light and the second type of light may differ with at maximum 0.01 for u' and/or with at maximum 0.01 for v'. Here, u' and v' are color coordinate of the light in the CIE 1976 UCS (uniform chromaticity scale) diagram. The color points indicated with u',v' especially refer to the CIE 1976 color points (see ISO CIE 11664-5: Colorimetry - Part5: CIE 1976 L*u*v* color space and u', v' uniform chromaticity scale diagram).

Hence, the system light may in embodiments be white light. The term "white light", and similar terms, herein, is known to the person skilled in the art. It may especially relate to light having a correlated color temperature (CCT) between about 1800 K and 20000 K, such as between 2000 and 20000 K, especially 2700-20000 K, for general lighting especially in the range of about 2000-7000 K, such as in the range of 2700 K and 6500 K. In embodiments, e.g. for backlighting purposes, or for other purposes, the correlated color temperature (CCT) may especially be in the range of about 7000 K and 20000 K. Yet further, in embodiments the correlated color temperature (CCT) is especially within about 15 SDCM (standard deviation of color matching) from the BBL (black body locus), especially within about 10 SDCM from the BBL, even more especially within about 5 SDCM from the BBL.

In specific embodiments, the correlated color temperature (CCT) may be selected from the range of 6000-12000 K, like selected from the range of 7000-12000 K, like at least 8000 K. Yet further, in embodiments the correlated color temperature (CCT) may be selected from the range of 6000-12000 K, like selected from the range of 7000-12000 K, in combination with a CRI of at least 70.

In an embodiment, the light source may also provide light source light having a correlated color temperature (CCT) between about 5000 and 20000 K, e.g. direct phosphor converted LEDs (blue light emitting diode with thin layer of phosphor for e.g. obtaining of 10000 K). Hence, in a specific embodiment the light source is configured to provide light source light with a correlated color temperature in the range of 5000-20000 K, even more especially in the range of 6000-20000 K, such as 8000-20000 K. An advantage of the relative high color temperature may be that there may be a relatively high blue component in the light source light.

The terms "visible", "visible light" or "visible emission" and similar terms refer to light having one or more wavelengths in the range of about 380-780 nm. Herein, UV may especially refer to a wavelength selected from the range of 190-380 nm, such as 200-380 nm.

The terms "light" and "radiation" are herein interchangeably used, unless clear from the context that the term "light" only refers to visible light. The terms "light" and "radiation" may thus refer to UV radiation, visible light, and IR radiation. In specific embodiments, especially for lighting applications, the terms "light" and "radiation" refer to (at least) visible light.

Further, in specific embodiments the system light in the first operational mode and in the second operational mode has a color rendering index of at least 80, more especially at least 82. In specific embodiments, the system light in the first operational mode and in the second operational mode has a color rendering index of at least 85.

The light generating system may be part of or may be applied in e.g. office lighting systems, household application systems, shop lighting systems, home lighting systems, accent lighting systems, spot lighting systems, theater lighting systems, fiber-optics application systems, projection systems, self-lit display systems, pixelated display systems, segmented display systems, warning sign systems, medical lighting application systems, indicator sign systems, decorative lighting systems, portable systems, automotive applications, (outdoor) road lighting systems, urban lighting systems, green house lighting systems, horticulture lighting, digital projection, or LCD backlighting. The light generating system (or luminaire) may be part of or may be applied in e.g. optical communication systems or disinfection systems.

In yet a further aspect, the invention also provides a lamp or a luminaire comprising the light generating system as defined herein. The luminaire may further comprise a housing, optical elements, louvres, etc. etc... The lamp or luminaire may further comprise a housing enclosing the light generating system. The lamp or luminaire may comprise a light window in the housing or a housing opening, through which the system light may escape from the housing. In yet a further aspect, the invention also provides a projection device comprising the light generating system as defined herein. Especially, a projection device or "projector" or "image projector" may be an optical device that projects an image (or moving images) onto a surface, such as e.g. a projection screen. The projection device may include one or more light generating systems such as described herein. Hence, in an aspect the invention also provides a lighting device selected from the group of a lamp, a luminaire, a projector device, a disinfection device, a photochemical reactor, and an optical wireless communication device, comprising the light generating system as defined herein. The lighting device may comprise a housing or a carrier, configured to house or support, one or more elements of the light generating system. For instance, in embodiments the lighting device may comprise a housing or a carrier, configured to house or support one or more of the first light generating device, the second light generating device, the third light generating device, etc. The lighting device may also be an automotive lighting device, such as a headlamp (or headlight) of a motorized vehicle (like a car, a truck, a bus, a coach, a tractor, a boat, an airplane, etc.).

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figs. 1a-1b schematically depict some embodiments;
Figs. 2a-2b show some spectral power distributions;
Fig. 3 shows some further spectral aspects; and
Fig. 4 schematically depict some application embodiments.

The schematic drawings are not necessarily to scale.

### DETAILED DESCRIPTION OF THE EMBODIMENTS

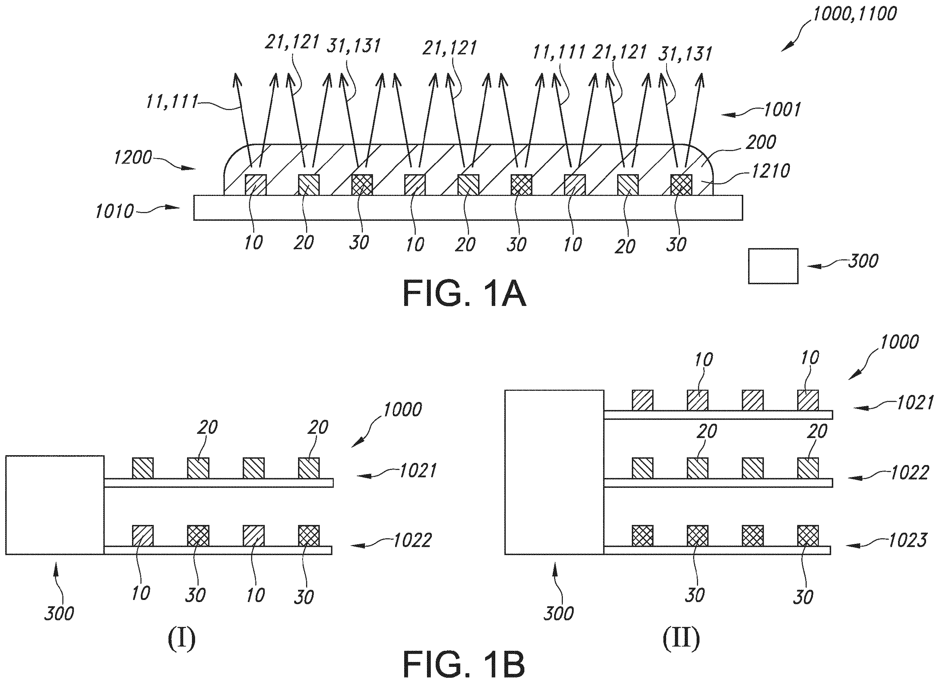

Fig. 1a schematically depicts an embodiment of a light generating system 1000 comprising a first light generating device 110, a second light generating device 120, a third light generating device 130, a luminescent material 200, and optionally a control system 300.

Especially, in embodiments the first light generating device 110 may be configured to generate first device light 111 having a first dominant wavelength λ1 selected from the wavelength range of 380-430 nm. Further, in embodiments the second light generating device 120 may be configured to generate second device light 121 having a second dominant wavelength λ2 selected from the wavelength range of 430-470 nm. Yet, in embodiments the third light generating device 130 may be configured to generate third device light 131 having a third dominant wavelength λ3 selected from the wavelength range of 470-520 nm. Especially, in embodiments λ1< λ2< λ3. In specific embodiments, the first dominant wavelength λ1, the second dominant wavelength λ2, and the third dominant wavelength λ3 may mutually differ at least 5 nm. Further, in embodiments each of the first light generating device 110, the second light generating device 120, and the third light generating device 130 may comprise a solid state light source.

Especially, in embodiments the first dominant wavelength λ1 may be selected from the wavelength range of 380-420 nm, the second dominant wavelength λ2 selected from the wavelength range of 440-460 nm; and the third dominant wavelength λ3 selected from the wavelength range of 470-520 nm; and wherein each of the first light generating device 110, the second light generating device 120, and the third light generating device 130 may comprise a light emitting diode. Yet further, in embodiments the first dominant wavelength λ1 may be selected from the wavelength range of 400-410 nm and/or the third dominant wavelength λ3 may be selected from the wavelength range of 480-490 nm.

Especially, the luminescent material 200 may be configured to convert (a) at least part of the first device light 111 received by the luminescent material 200 into luminescent material light 201, (b) at least part of the second device light 121 received by the luminescent material 200 into luminescent material light 201, and (c) at least part of the third device light 131 received by the luminescent material 200 into luminescent material light 201.

Further, in embodiments the first dominant wavelength λ1, the second dominant wavelength λ2, the third dominant wavelength λ3, and the luminescent material 200 may be selected such that (a) second luminescent conversion C2 of the second device light 121 by the luminescent material 200 may be a higher than a first luminescent conversion C1 of the first device light 111 by the luminescent material 200 and (b) higher than a third luminescent conversion C3 of the third device light 131 by the luminescent material 200.

In embodiments, the light generating system 1000 may be configured to generate (white) system light 1001 comprising the luminescent material light 201 and one or more of the first device light 111, the second device light 121, the third device light 131.

In specific embodiments, the control system 300 may be configured to control a first radiant flux Φ1 of the first light generating device, a second radiant flux Φ2 of the second light generating device, and a third radiant flux Φ3 of the third light generating device. Especially, in embodiments in a first operational mode M1 of the light generating system 1000, the system light 1001 may comprise the second device light 121 and the luminescent material light 201, and in a second operational mode M2 of the light generating system 1000, the system light 1001 may comprise the first device light 111, the third device light 131, and the luminescent material light 201.

In embodiments, a ratio R1 of radiant fluxes of the device light 111,121,131, wherein R1=(Φ1+Φ3)/(Φ2), may be smaller in the first operational mode than in the second operational mode. This may also imply in specific embodiments that either (a) Φ1+Φ3 is zero in the first operational mode and Φ2 is non-zero in the first operational mode, or (b) Φ1+Φ3 is non-zero in the second operational mode and Φ2 is zero in the second operational mode.

Further, in embodiments a first operational mode first radiant flux Φ11 of the first device light 111 in the first operational mode may be smaller than a second operational mode first radiant flux Φ21 of the first device light 111 in the second operational mode, and/or a first operational mode second radiant flux Φ12 of the second device light 121 in the first operational mode may be larger than a second operational mode second radiant flux Φ22 of the second device light 121 in the second operational mode; and/or a first operational mode third radiant flux Φ13 of the third device light 131 in the first operational mode may be smaller than a second operational mode third radiant flux Φ23 of the third device light 131 in the second operational mode.

In specific embodiments, 0.1≤C1/C2≤0.7 and/or wherein 0.1≤C3/C2≤0.7. Further, in specific embodiments 0.3≤C2/C3≤0.95.

As schematically depicted, the system may comprise an encapsulant 1200, wherein the encapsulant 1200 (at least partly) may cover the first light generating device 110, the second light generating device 120, and the third light generating device 130; wherein the encapsulant 1200 may comprise a light transmissive host material 1210 with the luminescent material 200 embedded therein.

In embodiments, the luminescent material 200 at least may comprise a first luminescent material 210 comprising a luminescent material of the type A₃B₅O₁₂:Ce, wherein A may comprise one or more of Y, La, Gd, Tb and Lu, and wherein B may comprise one or more of Al, Ga, In and Sc. Alternatively or additionally, in embodiments the luminescent material 200 at least may comprise a second luminescent material 220 configured to convert at least part of the device light 111,121,131 when received by the second luminescent material 202 into second luminescent light 221 having a wavelength in the orange-red wavelength range. In specific embodiments, the second luminescent material 220 may comprise one or more luminescent materials selected from the group of a red emitting divalent europium based nitride phosphor and a red emitting tetravalent manganese based fluoride phosphor.

References 10, 20, and 30 refer to first solid state light sources, second solid state light sources, and third solid state light sources, comprised by respectively the first light generating devices 110, the second light generating devices 120, and the third light generating devices 130. Reference 1010 refers to a substrate (for the light generating devices 110,120,130). The first device light 111 may essentially consist of first solid state light source light 11. The second device light 121 may essentially consist of second solid state light source light 21. The third device light 131 may essentially consist of third solid state light source light 31.

Fig. 1a schematically depicts an embodiment of a cross-sectional view of a COB or a LED filament. Hence, the light generating system 1000 may comprise a chips-on-board device 1100, wherein the chips-on-board device 1100 may comprise the first light generating device 110, the second light generating device 120, the third light generating device 130, and the luminescent material 200. However, the system 100 may also comprise a LED filament, wherein the LED filament may comprise the first light generating device 110, the second light generating device 120, the third light generating device 130, and the luminescent material 200.

Referring to Fig. 1b (but in fact also Fig. 1a), the system 1000 may comprise N1 first light generating devices 110, N2 second light generating devices 120, and N3 third light generating devices 130, wherein N1+N2+N3≥20. Here, by way of example only a few light generating devices are depicted. In embodiments, 0.7≤N1/N3≤1.3 and N1≥3. References 1021,1022,1023 refer to LED strings.

As indicated above, the system 1000 may comprise a first LED string 1021, wherein the second light generating devices are comprised by the first LED string, and a second LED string 1022, wherein the first light generating devices and the third light generating devices are comprised by the first LED string. In such embodiments, the control system may control the LED strings individually, and may the second light generating devices on the one hand, and the first light generating devices and the third light generating devices on the other hand be controlled as respective (two) groups.

In alternative embodiments, the system may comprise a first LED string, wherein the first light generating devices are comprised by the first LED string 1021, a second LED string 1022, wherein the second light generating devices are comprised by the second LED string, and a third LED string 1031, wherein the third light generating devices are comprised by the third LED string. In such embodiments, the control system may control the LED strings individually, and may the first light generating devices, the second light generating devices, and the third light generating devices be controlled as respective (three) groups. Hence, in embodiments the control system may control two or more LED strings, wherein the light generating devices may comprise by the two or more LED strings.

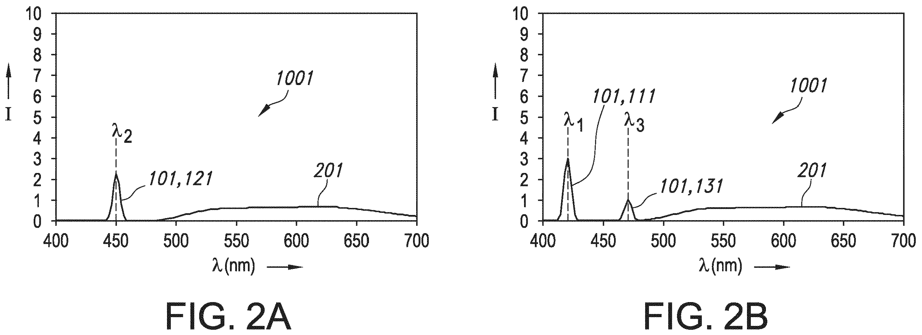

Figs. 2a-2b show spectral power distributions of e.g. the two different modes. Fig. 2a shows system light 1001 having a CCT of about 3527, a CRI of about 82, and a R9 of about 47. Fig. 2b shows system light 1001 having a CCT of about 3510, a CRI of about 82, and a R9 of about 47. On the y-axis, the intensity in W/nm may be indicated, on the x-axis the wavelength in nm.

Hence, in specific embodiments the system light 1001 in the first operational mode has a first correlated color temperature CCT1, wherein the system light 1001 in the second operational mode has a second correlated color temperature CCT2, wherein |CCT1-CCT2|≤ 300 K; and/or the system light 1001 in the first operational mode and in the second operational mode has a color rendering index of at least 80.

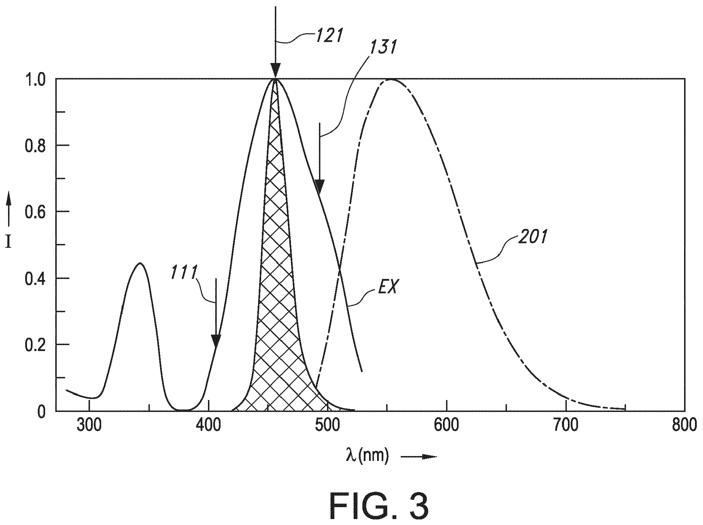

Referring to Fig. 3, an excitation spectrum EX of a luminescent material 200 may be shown. The luminescent material light may be indicated with reference 201. Assuming the first dominant wavelength to be in the maximum (though) this may be not necessarily the case, C2=1, C1=0.2, and C3=0.65. Hence, C1<C2, and C3<C1. Hence, C1, C2, and C3 may scale as the oscillator strengths at the position of the respective dominant wavelengths. Therefore, C1, C2, and C3 may be derived from the excitation spectrum. As shown, the first dominant wavelength λ1, the second dominant wavelength λ2, the third dominant wavelength λ3, and the luminescent material 200 may be selected such that (a) second luminescent conversion C2 of the second device light 121 by the luminescent material 200 may be a higher than a first luminescent conversion C1 of the first device light 111 by the luminescent material 200 and (b) higher than a third luminescent conversion C3 of the third device light 131 by the luminescent material 200. In specific embodiments, 0.1≤C1/C2≤0.7 and/or wherein 0.1≤C3/C2≤0.7. Further, in specific embodiments 0.3≤C2/C3≤0.95.

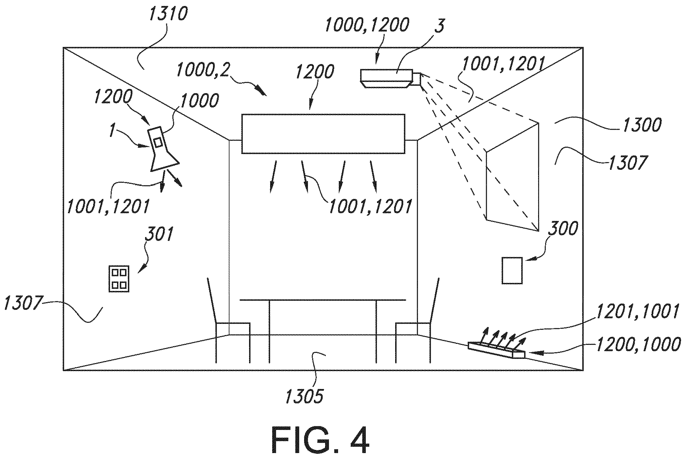

Fig. 4 schematically depicts an embodiment of a luminaire 2 comprising the light generating system 1000 as described above. Reference 301 indicates a user interface which may be functionally coupled with the control system 300 comprised by or functionally coupled to the light generating system 1000. Fig. 4 also schematically depicts an embodiment of lamp 1 comprising the light generating system 1000. Reference 3 indicates a projector device or projector system, which may be used to project images, such as at a wall, which may also comprise the light generating system 1000. Hence, Fig. 4 schematically depicts embodiments of a lighting device 1200 selected from the group of a lamp 1, a luminaire 2, a projector device 3, a disinfection device, a photochemical reactor, and an optical wireless communication device, comprising the light generating system 1000 as described herein. In embodiments, such lighting device may be a lamp 1, a luminaire 2, a projector device 3, a disinfection device, or an optical wireless communication device. Lighting device light escaping from the lighting device 1200 is indicated with reference 1201. Lighting device light 1201 may essentially consist of system light 1001, and may in specific embodiments thus be system light 1001. Reference 1300 refers to a space, such as a room. Reference 1305 refers to a floor and reference 1310 to a ceiling; reference 1307 refers to a wall. The lighting device may also be an automotive light device, such as a headlamp.

The term "plurality" refers to two or more.

The terms "substantially" or "essentially" herein, and similar terms, will be understood by the person skilled in the art. The terms "substantially" or "essentially" may also include embodiments with "entirely", "completely", "all", etc. Hence, in embodiments the adjective substantially or essentially may also be removed. Where applicable, the term "substantially" or the term "essentially" may also relate to 90% or higher, such as 95% or higher, especially 99% or higher, even more especially 99.5% or higher, including 100%.

The term "comprise" also includes embodiments wherein the term "comprises" means "consists of".

The term "and/or" especially relates to one or more of the items mentioned before and after "and/or". For instance, a phrase "item 1 and/or item 2" and similar phrases may relate to one or more of item 1 and item 2. The term "comprising" may in an embodiment refer to "consisting of" but may in another embodiment also refer to "containing at least the defined species and optionally one or more other species".

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

The devices, apparatus, or systems may herein amongst others be described during operation. As will be clear to the person skilled in the art, the invention is not limited to methods of operation, or devices, apparatus, or systems in operation.

It should be noted that the above-mentioned embodiments illustrate rather than limit the invention, and that those skilled in the art will be able to design many alternative embodiments without departing from the scope of the appended claims.

In the claims, any reference signs placed between parentheses shall not be construed as limiting the claim.

Use of the verb "to comprise" and its conjugations does not exclude the presence of elements or steps other than those stated in a claim. Unless the context clearly requires otherwise, throughout the description and the claims, the words "comprise", "comprising", and the like are to be construed in an inclusive sense as opposed to an exclusive or exhaustive sense; that is to say, in the sense of "including, but not limited to".

The article "a" or "an" preceding an element does not exclude the presence of a plurality of such elements.

The invention may be implemented by means of hardware comprising several distinct elements, and by means of a suitably programmed computer. In a device claim, or an apparatus claim, or a system claim, enumerating several means, several of these means may be embodied by one and the same item of hardware. The mere fact that certain measures are recited in mutually different dependent claims does not indicate that a combination of these measures cannot be used to advantage. In yet a further aspect, the invention (thus) provides a software product, which, when running on a computer is capable of bringing about (one or more embodiments of) the method as described herein.

The invention also provides a control system that may control the device, apparatus, or system, or that may execute the herein described method or process. Yet further, the invention also provides a computer program product, when running on a computer which is functionally coupled to or comprised by the device, apparatus, or system, controls one or more controllable elements of such device, apparatus, or system.

The invention further applies to a device, apparatus, or system comprising one or more of the characterizing features described in the description and/or shown in the attached drawings. The invention further pertains to a method or process comprising one or more of the characterizing features described in the description and/or shown in the attached drawings.

## Claims

1. A light generating system (1000) comprising a first light generating device (110), a second light generating device (120), a third light generating device (130), a luminescent material (200), and a control system (300), wherein:
- the first light generating device (110) is configured to generate first device light (111) having a first dominant wavelength, λ1, selected from the wavelength range of 380-430 nm;
- the second light generating device (120) is configured to generate second device light (121) having a second dominant wavelength, λ2, selected from the wavelength range of 430-470 nm;
- the third light generating device (130) is configured to generate third device light (131) having a third dominant wavelength, λ3, selected from the wavelength range of 470-520 nm;
- λ1 < λ2< λ3; wherein the first dominant wavelength, λ1, the second dominant wavelength, λ2, and the third dominant wavelength λ3, mutually differ at least 5 nm; and wherein each of the first light generating device (110), the second light generating device (120), and the third light generating device (130) comprises a solid state light source;
- the luminescent material (200) is configured to convert (a) at least part of the first device light (111) received by the luminescent material (200) into luminescent material light (201), (b) at least part of the second device light (121) received by the luminescent material (200) into luminescent material light (201), and (c) at least part of the third device light (131) received by the luminescent material (200) into luminescent material light (201);
- the first dominant wavelength, λ1, the second dominant wavelength, λ2, the third dominant wavelength, λ3, and the luminescent material (200) are selected such that a second luminescent conversion, C2, of the second device light (121) by the luminescent material (200) is (a) higher than a first luminescent conversion, C1, of the first device light (111) by the luminescent material (200) and (b) higher than a third luminescent conversion, C3, of the third device light (131) by the luminescent material (200);
- the light generating system (1000) is configured to generate system light (1001) comprising the luminescent material light (201) and one or more of the first device light (111), the second device light (121), the third device light (131);
- the control system (300) is configured to control a first radiant flux, Φ1, of the first light generating device, a second radiant flux, Φ2, of the second light generating device, and a third radiant flux, Φ3, of the third light generating device, wherein:
- in a first operational mode, M1, of the light generating system (1000), the system light (1001) comprises the second device light (121) and the luminescent material light (201); wherein the system light (1001) is white light;
- in a second operational mode, M2, of the light generating system (1000), the system light (1001) comprises the first device light (111), the third device light (131), and the luminescent material light (201); wherein the system light (1001) is white light;
- a ratio R1 of radiant fluxes of the first device light, second device light, and third device light (111,121,131) is smaller in the first operational mode than in the second operational mode, wherein R1=(Φ1+Φ3)/(Φ2).

2. The light generating system (1000) according to claim 1, wherein the first dominant wavelength, λ1, is selected from the wavelength range of 380-420 nm, the second dominant wavelength, λ2, selected from the wavelength range of 440-460 nm; and the third dominant wavelength, λ3, selected from the wavelength range of 470-520 nm; and wherein each of the first light generating device (110), the second light generating device (120), and the third light generating device (130) comprises a light emitting diode; wherein R1 in the first operational mode is at maximum 0.9, and wherein R1 in the second operational mode is at least 1.1.

3. The light generating system (1000) according to any one of the preceding claims, wherein the first dominant wavelength, λ1, is selected from the wavelength range of 400-410 nm; and wherein the third dominant wavelength, λ3, is selected from the wavelength range of 480-490 nm.

4. The light generating system (1000) according to any one of the preceding claims, a first operational mode first radiant flux, Φ11, of the first device light (111) in the first operational mode is smaller than a second operational mode first radiant flux, Φ21, of the first device light (111) in the second operational mode;
- a first operational mode second radiant flux, Φ12, of the second device light (121) in the first operational mode is larger than a second operational mode second radiant flux, Φ22, of the second device light (121) in the second operational mode; and
- a first operational mode third radiant flux, Φ13, of the third device light (131) in the first operational mode is smaller than a second operational mode third radiant flux, Φ23, of the third device light (131) in the second operational mode.

5. The light generating system (1000) according to any one of the preceding claims, wherein the control system (300) is configured to maintain a radiant flux of the system light (1001) in the operational modes.

6. The light generating system (1000) according to any one of the preceding claims, wherein 0.1≤C1/C2≤0.7 and/or wherein 0.1≤C3/C2≤0.7.

7. The light generating system (1000) according to any one of the preceding claims, comprising an encapsulant (1200), wherein the encapsulant (1200) covers the first light generating device (110), the second light generating device (120), and the third light generating device (130); wherein the encapsulant (1200) comprises a light transmissive host material (1210) with the luminescent material (200) embedded therein.

8. The light generating system (1000) according to any one of the preceding claims, wherein the luminescent material (200) at least comprises a first luminescent material (210) comprising a luminescent material of the type A₃B₅O₁₂:Ce, wherein A comprises one or more of Y, La, Gd, Tb and Lu, and wherein B comprises one or more of Al, Ga, In and Sc.

9. The light generating system (1000) according to any one of the preceding claims, wherein the luminescent material (200) at least comprises a second luminescent material (220) configured to convert at least part of the device light (111,121,131) when received by the second luminescent material (202) into second luminescent light (221) having a wavelength in the orange-red wavelength range; wherein the second luminescent material (220) comprises one or more luminescent materials selected from the group of a red emitting divalent europium based nitride phosphor, a red emitting tetravalent manganese based fluoride phosphor, and a red emitting quantum structure.

10. The light generating system (1000) according to any one of the preceding claims, comprising N1 first light generating devices (110), N2 second light generating devices (120), and N3 third light generating devices (130), wherein N1+N2+N3≥20.

11. The light generating system (1000) according to claim 10, wherein 0.7≤N1/N3≤1.3 and wherein N1≥3.

12. The light generating system (1000) according to any one of the preceding claims, comprising a chips-on-board device (1100), wherein the chips-on-board device (1100) comprises the first light generating device (110), the second light generating device (120), the third light generating device (130), and the luminescent material (200).

13. The light generating system (1000) according to any one of the preceding claims, comprising a LED filament, wherein the LED filament comprises the first light generating device (110), the second light generating device (120), the third light generating device (130), and the luminescent material (200).

14. The light generating system (1000) according to any one of the preceding claims, wherein the system light (1001) in the first operational mode has a first correlated color temperature CCT1, wherein the system light (1001) in the second operational mode has a second correlated color temperature CCT2, wherein |CCT1-CCT2|≤ 300 K; and wherein the system light (1001) in the first operational mode and in the second operational mode has a color rendering index of at least 80.

15. A lighting device (1200) selected from the group of a lamp (1), a luminaire (2), a projector device (3), a disinfection device, a photochemical reactor, automotive lighting device, and an optical wireless communication device, comprising the light generating system (1000) according to any one of the preceding claims.

## Patentansprüche

1. Lichterzeugungssystem (1000), umfassend eine erste Lichterzeugungsvorrichtung (110), eine zweite Lichterzeugungsvorrichtung (120), eine dritte Lichterzeugungsvorrichtung (130), einen Leuchtstoff (200) und ein Steuersystem (300), wobei:
- die erste Lichterzeugungsvorrichtung (110) konfiguriert ist, um ein erstes Vorrichtungslicht (111) zu erzeugen, das eine erste farbtongleiche Wellenlänge, λ1, die aus dem Wellenlängenbereich von 380-430 nm ausgewählt ist, aufweist;
- die zweite Lichterzeugungsvorrichtung (120) konfiguriert ist, um ein zweites Vorrichtungslicht (121) zu erzeugen, das eine zweite farbtongleiche Wellenlänge, λ2, die aus dem Wellenlängenbereich von 430-470 nm ausgewählt ist, aufweist;
- die dritte Lichterzeugungsvorrichtung (130) konfiguriert ist, um ein drittes Vorrichtungslicht (131) zu erzeugen, das eine dritte farbtongleiche Wellenlänge, λ3, die aus dem Wellenlängenbereich von 470-520 nm ausgewählt ist, aufweist;
- λ1< λ2< λ3; wobei sich die erste farbtongleiche Wellenlänge, λ1, die zweite farbtongleiche Wellenlänge, λ2, und die dritte farbtongleiche Wellenlänge λ3 um mindestens 5 nm voneinander unterscheiden; und wobei jede der ersten Lichterzeugungsvorrichtung (110), der zweiten Lichterzeugungsvorrichtung (120) und der dritten Lichterzeugungsvorrichtung (130) eine Festkörperlichtquelle umfasst;
- der Leuchtstoff (200) konfiguriert ist, um (a) mindestens einen Teil des ersten Vorrichtungslichts (111), das durch den Leuchtstoff (200) aufgenommen wird, in Leuchtstofflicht (201), (b) mindestens einen Teil des zweiten Vorrichtungslichts (121), das durch den Leuchtstoff (200) aufgenommen wird, in Leuchtstofflicht (201) und (c) mindestens einen Teil des dritten Vorrichtungslichts (131), das durch den Leuchtstoff (200) aufgenommen wird, in Leuchtstofflicht (201) umzuwandeln;
- die erste farbtongleiche Wellenlänge, λ1, die zweite farbtongleiche Wellenlänge, λ2, die dritte farbtongleiche Wellenlänge, λ3 und der Leuchtstoff (200) derart ausgewählt sind, dass eine zweite Lumineszenzumwandlung, C2, des zweiten Vorrichtungslichts (121) durch den Leuchtstoff (200) (a) höher als eine erste Lumineszenzumwandlung, C1, des ersten Vorrichtungslichts (111) durch den Leuchtstoff (200) und (b) höher als eine dritte Lumineszenzumwandlung, C3, des dritten Vorrichtungslichts (131) durch den Leuchtstoff (200) ist;
- das Lichterzeugungssystem (1000) konfiguriert ist, um Systemlicht (1001), umfassend das Leuchtstofflicht (201) und eines oder mehrere von dem ersten Vorrichtungslicht (111), dem zweiten Vorrichtungslicht (121) und dem dritten Vorrichtungslicht (131), zu erzeugen;
- das Steuersystem (300) konfiguriert ist, um einen ersten Strahlungsfluss, Φ1, der ersten Lichterzeugungsvorrichtung, einen zweiten Strahlungsfluss, Φ2, der zweiten Lichterzeugungsvorrichtung und einen dritten Strahlungsfluss, Φ3, der dritten Lichterzeugungsvorrichtung zu steuern, wobei:
- in einem ersten Betriebsmodus, M1, des Lichterzeugungssystems (1000) das Systemlicht (1001) das zweite Vorrichtungslicht (121) und das Leuchtstofflicht (201) umfasst; wobei das Systemlicht (1001) weißes Licht ist;
- in einem zweiten Betriebsmodus, M2, des Lichterzeugungssystems (1000) das Systemlicht (1001) das erste Vorrichtungslicht (111), das dritte Vorrichtungslicht (131) und das Leuchtstofflicht (201) umfasst; wobei das Systemlicht (1001) weißes Licht ist;
- ein Verhältnis R1 von Strahlungsflüssen des ersten Vorrichtungslichts, des zweiten Vorrichtungslichts und des dritten Vorrichtungslichts (111,121,131) in dem ersten Betriebsmodus kleiner als in dem zweiten Betriebsmodus ist, wobei R1=(Φ1+Φ3)/(Φ2).

2. Lichterzeugungssystem (1000) nach Anspruch 1, wobei die erste farbtongleiche Wellenlänge, λ1, aus dem Wellenlängenbereich von 380-420 nm ausgewählt ist, die zweite farbtongleiche Wellenlänge, λ2, aus dem Wellenlängenbereich von 440-460 nm ausgewählt ist; und die dritte farbtongleiche Wellenlänge, λ3, aus dem Wellenlängenbereich von 470-520 nm ausgewählt ist; und wobei jede von der ersten Lichterzeugungsvorrichtung (110), der zweiten Lichterzeugungsvorrichtung (120) und der dritten Lichterzeugungsvorrichtung (130) eine lichtemittierende Diode umfasst; wobei R1 in dem ersten Betriebsmodus maximal 0,9 ist, und wobei R1 in dem zweiten Betriebsmodus mindestens 1,1 ist.

3. Lichterzeugungssystem (1000) nach einem der vorstehenden Ansprüche, wobei die erste farbtongleiche Wellenlänge, λ1, aus dem Wellenlängenbereich von 400-410 nm ausgewählt ist; und wobei die dritte farbtongleiche Wellenlänge, λ3, aus dem Wellenlängenbereich von 480-490 nm ausgewählt ist.

4. Lichterzeugungssystem (1000) nach einem der vorstehenden Ansprüche, wobei ein erster Strahlungsfluss, Φ11, des ersten Betriebsmodus des ersten Vorrichtungslichts (111) in dem ersten Betriebsmodus kleiner als ein erster Strahlungsfluss, Φ21, des zweiten Betriebsmodus des ersten Vorrichtungslichts (111) in dem zweiten Betriebsmodus ist;
- ein zweiter Strahlungsfluss, Φ12, des ersten Betriebsmodus des zweiten Vorrichtungslichts (121) in dem ersten Betriebsmodus größer als ein zweiter Strahlungsfluss, Φ22, des zweiten Betriebsmodus des zweiten Vorrichtungslichts (121) in dem zweiten Betriebsmodus ist; und
- ein dritter Strahlungsfluss, Φ13, des ersten Betriebsmodus des dritten Vorrichtungslichts (131) in dem ersten Betriebsmodus kleiner als ein dritter Strahlungsfluss, Φ23, des zweiten Betriebsmodus des dritten Vorrichtungslichts (131) in dem zweiten Betriebsmodus ist.

5. Lichterzeugungssystem (1000) nach einem der vorstehenden Ansprüche, wobei das Steuersystem (300) konfiguriert ist, um einen Strahlungsfluss des Systemlichts (1001) in den Betriebsmodi aufrechtzuerhalten.

6. Lichterzeugungssystem (1000) nach einem der vorstehenden Ansprüche, wobei 0,1≤C1/C2≤0,7 und/oder wobei 0,1≤C3/C2≤0,7.

7. Lichterzeugungssystem (1000) nach einem der vorstehenden Ansprüche, umfassend ein Verkapselungsmittel (1200), wobei das Verkapselungsmittel (1200) die erste Lichterzeugungsvorrichtung (110), die zweite Lichterzeugungsvorrichtung (120) und die dritte Lichterzeugungsvorrichtung (130) abdeckt; wobei das Verkapselungsmittel (1200) ein lichtdurchlässiges Grundmaterial (1210) mit dem darin eingebetteten Leuchtstoff (200) umfasst.

8. Lichterzeugungssystem (1000) nach einem der vorstehenden Ansprüche, wobei der Leuchtstoff (200) mindestens einen ersten Leuchtstoff (210), umfassend einen Leuchtstoff von der Art A₃B₅O₁₂:Ce, umfasst, wobei A eines oder mehrere von Y, La, Gd, Tb und Lu umfasst, und wobei B eines oder mehrere von Al, Ga, In und Sc umfasst.

9. Lichterzeugungssystem (1000) nach einem der vorstehenden Ansprüche, wobei der Leuchtstoff (200) mindestens einen zweiten Leuchtstoff (220) umfasst, der konfiguriert ist, um mindestens einen Teil des Vorrichtungslichts (111,121,131), wenn es durch den zweiten Leuchtstoff (202) aufgenommen wird, in zweites Leuchtstofflicht (221), das eine Wellenlänge in dem orange-roten Wellenlängenbereich aufweist, umzuwandeln; wobei der zweite Leuchtstoff (220) ein oder mehrere Leuchtstoffe, die aus der Gruppe von einem rot emittierenden Nitridphosphor auf Basis von zweiwertigem Europium, einem rot emittierenden Fluoridphosphor auf Basis von vierwertigem Mangan und einer rot emittierenden Quantenstruktur ausgewählt sind, umfasst.

10. Lichterzeugungssystem (1000) nach einem der vorstehenden Ansprüche, umfassend N1 erste Lichterzeugungsvorrichtungen (110), N2 zweite Lichterzeugungsvorrichtungen (120) und N3 dritte Lichterzeugungsvorrichtungen (130), wobei N1+N2+N3≥20.

11. Lichterzeugungssystem (1000) nach Anspruch 10, wobei 0,7≤N1/N3≤1,3 und wobei N1≥3.

12. Lichterzeugungssystem (1000) nach einem der vorstehenden Ansprüche, umfassend eine Chips-on-Board-Vorrichtung (1100), wobei die Chips-on-Board-Vorrichtung (1100) die erste Lichterzeugungsvorrichtung (110), die zweite Lichterzeugungsvorrichtung (120), die dritte Lichterzeugungsvorrichtung (130) und den Leuchtstoff (200) umfasst.

13. Lichterzeugungssystem (1000) nach einem der vorstehenden Ansprüche, umfassend ein LED-Filament, wobei das LED-Filament die erste Lichterzeugungsvorrichtung (110), die zweite Lichterzeugungsvorrichtung (120), die dritte Lichterzeugungsvorrichtung (130) und den Leuchtstoff (200) umfasst.

14. Lichterzeugungssystem (1000) nach einem der vorstehenden Ansprüche, wobei das Systemlicht (1001) in dem ersten Betriebsmodus eine erste korrelierte Farbtemperatur CCT1 aufweist, wobei das Systemlicht (1001) in dem zweiten Betriebsmodus eine zweite korrelierte Farbtemperatur CCT2 aufweist, wobei |CCT1-CCT2|≤300 K; und wobei das Systemlicht (1001) in dem ersten Betriebsmodus und in dem zweiten Betriebsmodus einen Farbwiedergabeindex von mindestens 80 aufweist.

15. Beleuchtungsvorrichtung (1200), die aus der Gruppe einer Lampe (1), einer Leuchte (2), einer Projektorvorrichtung (3), einer Desinfektionsvorrichtung, einem photochemischen Reaktor, einer Automobilbeleuchtungsvorrichtung und einer optischen drahtlosen Kommunikationsvorrichtung ausgewählt ist, umfassend das Lichterzeugungssystem (1000) nach einem der vorstehenden Ansprüche.

## Revendications

1. Système générateur de lumière (1000) comprenant un premier dispositif générateur de lumière (110), un deuxième dispositif générateur de lumière (120), un troisième dispositif générateur de lumière (130), un matériau luminescent (200) et un système de commande (300), dans lequel :
- le premier dispositif générateur de lumière (110) est configuré pour générer de la lumière de premier dispositif (111) ayant une première longueur d'onde dominante, λ1, sélectionnée dans la plage de longueur d'onde de 380 à 430 nm ;
- le deuxième dispositif générateur de lumière (120) est configuré pour générer de la lumière de deuxième dispositif (121) ayant une deuxième longueur d'onde dominante, λ2, sélectionnée dans la plage de longueur d'onde de 430 à 470 nm ;
- le troisième dispositif générateur de lumière (130) est configuré pour générer de la lumière de troisième dispositif (131) ayant une troisième longueur d'onde dominante, λ3, sélectionnée dans la plage de longueur d'onde de 470 à 520 nm ;
- λ1< λ2< λ3 ; dans lequel la première longueur d'onde dominante, λ1, la deuxième longueur d'onde dominante, λ2, et la troisième longueur d'onde dominante λ3, diffèrent mutuellement d'au moins 5 nm ; et dans lequel chacun parmi le premier dispositif générateur de lumière (110), le deuxième dispositif générateur de lumière (120) et le troisième dispositif générateur de lumière (130) comprend une source de lumière à semi-conducteurs ;
- le matériau luminescent (200) est configuré pour convertir (a) au moins une partie de la lumière de premier dispositif (111) reçue par le matériau luminescent (200) en lumière de matériau luminescent (201), (b) au moins une partie de la lumière de deuxième dispositif (121) reçue par le matériau luminescent (200) en lumière de matériau luminescent (201), et (c) au moins une partie de la lumière de troisième dispositif (131) reçue par le matériau luminescent (200) en lumière de matériau luminescent (201) ;
- la première longueur d'onde dominante, λ1, la deuxième longueur d'onde dominante, λ2, la troisième longueur d'onde dominante, λ3, et le matériau luminescent (200) sont sélectionnés de telle sorte qu'une deuxième conversion luminescente, C2, de la lumière de deuxième dispositif (121) par le matériau luminescent (200) est (a) supérieure à une première conversion luminescente, C1, de la lumière de premier dispositif (111) par le matériau luminescent (200) et (b) supérieure à une troisième conversion luminescente, C3, de la lumière de troisième dispositif (131) par le matériau luminescent (200) ;
- le système générateur de lumière (1000) est configuré pour générer de la lumière de système (1001) comprenant la lumière de matériau luminescent (201) et une ou plusieurs parmi la lumière de premier dispositif (111), la lumière de deuxième dispositif (121) la lumière de troisième dispositif (131) ;
- le système de commande (300) est configuré pour commander un premier flux rayonnant, Φ1, du premier dispositif générateur de lumière, un deuxième flux rayonnant, Φ2, du deuxième dispositif générateur de lumière, et un troisième flux rayonnant, Φ3, du troisième dispositif générateur de lumière, dans lequel :
- dans un premier mode fonctionnel, M1, du système générateur de lumière (1000), la lumière de système (1001) comprend la lumière de deuxième dispositif (121) et la lumière de matériau luminescent (201) ; dans lequel la lumière de système (1001) est de la lumière blanche ;
- dans un second mode fonctionnel, M2, du système générateur de lumière (1000), la lumière de système (1001) comprend la lumière de premier dispositif (111), la lumière de troisième dispositif (131) et la lumière de matériau luminescent (201) ; dans lequel la lumière de système (1001) est de la lumière blanche ;
- un rapport R1 des flux rayonnants de la lumière de premier dispositif, de la lumière de deuxième dispositif et de la lumière de troisième dispositif (111, 121, 131) est plus petit dans le premier mode fonctionnel que dans le second mode fonctionnel, dans lequel R1=(Φ1+Φ3)/(Φ2).

2. Système générateur de lumière (1000) selon la revendication 1, dans lequel la première longueur d'onde dominante, λ1, est sélectionnée dans la plage de longueur d'onde de 380 à 420 nm, la deuxième longueur d'onde dominante, λ2, est sélectionnée dans la plage de longueur d'onde de 440 à 460 nm ; et la troisième longueur d'onde dominante, λ3, est sélectionnée dans la plage de longueur d'onde de 470 à 520 nm ; et dans lequel chacun parmi le premier dispositif générateur de lumière (110), le deuxième dispositif générateur de lumière (120) et le troisième dispositif générateur de lumière (130) comprend une diode électroluminescente ; dans lequel R1 dans le premier mode fonctionnel vaut au maximum 0,9, et dans lequel R1 dans le second mode fonctionnel vaut au moins 1,1.

3. Système générateur de lumière (1000) selon l'une quelconque des revendications précédentes, dans lequel la première longueur d'onde dominante, λ1, est sélectionnée dans la plage de longueur d'onde de 400 à 410 nm ; et dans lequel la troisième longueur d'onde dominante, λ3, est sélectionnée dans la plage de longueur d'onde de 480 à 490 nm.

4. Système générateur de lumière (1000) selon l'une quelconque des revendications précédentes, un premier flux rayonnant de premier mode fonctionnel, Φ11, de la lumière de premier dispositif (111) dans le premier mode fonctionnel est plus petit qu'un premier flux rayonnant de second mode fonctionnel, Φ21, de la lumière de premier dispositif (111) dans le second mode fonctionnel ;
- un deuxième flux rayonnant de premier mode fonctionnel, Φ12, de la lumière de deuxième dispositif (121) dans le premier mode fonctionnel est plus grand qu'un deuxième flux rayonnant de second mode fonctionnel, Φ22, de la lumière de deuxième dispositif (121) dans le second mode fonctionnel ; et
- un troisième flux rayonnant de premier mode fonctionnel, Φ13, de la lumière de troisième dispositif (131) dans le premier mode fonctionnel est plus petit qu'un troisième flux rayonnant de second mode fonctionnel, Φ23, de la lumière de troisième dispositif (131) dans le second mode fonctionnel.

5. Système générateur de lumière (1000) selon l'une quelconque des revendications précédentes, dans lequel le système de commande (300) est configuré pour maintenir un flux rayonnant de la lumière de système (1001) dans les modes fonctionnels.

6. Système générateur de lumière (1000) selon l'une quelconque des revendications précédentes, dans lequel 0,1≤C1/C2≤0,7 et/ou dans lequel 0,1≤C3/C2≤0,7.

7. Système générateur de lumière (1000) selon l'une quelconque des revendications précédentes, comprenant un encapsulant (1200), dans lequel l'encapsulant (1200) couvre le premier dispositif générateur de lumière (110), le deuxième dispositif générateur de lumière (120) et le troisième dispositif générateur de lumière (130) ; dans lequel l'encapsulant (1200) comprend un matériau hôte transmetteur de lumière (1210) avec le matériau luminescent (200) noyé dans celui-ci.

8. Système générateur de lumière (1000) selon l'une quelconque des revendications précédentes, dans lequel le matériau luminescent (200) comprend au moins un premier matériau luminescent (210) comprenant un matériau luminescent du type A₃B₅O₁₂:Ce, dans lequel A comprend un ou plusieurs parmi Y, La, Gd, Tb et Lu, et dans lequel B comprend un ou plusieurs parmi Al, Ga, In et Sc.

9. Système générateur de lumière (1000) selon l'une quelconque des revendications précédentes, dans lequel le matériau luminescent (200) comprend au moins un second matériau luminescent (220) configuré pour convertir au moins une partie de la lumière de dispositif (111,121,131) lorsqu'elle est reçue par le second matériau luminescent (202) en lumière de second matériau luminescent (221) ayant une longueur d'onde dans la plage de longueur d'onde orange-rouge ; dans lequel le second matériau luminescent (202) comprend un ou plusieurs matériaux luminescents sélectionnés dans le groupe d'un luminophore nitrure à base d'europium divalent à émission de rouge, d'un luminophore fluorure à base de manganèse tétravalent à émission de rouge et d'une structure quantique à émission de rouge.

10. Système générateur de lumière (1000) selon l'une quelconque des revendications précédentes, comprenant N1 premiers dispositifs générateurs de lumière (110), N2 deuxièmes dispositifs générateurs de lumière (120), et N3 troisièmes dispositifs générateurs de lumière (130), dans lequel N1+N2+N3≥20.

11. Système générateur de lumière (1000) selon la revendication 10, dans lequel 0,7≤N1/N3≤1,3 et dans lequel N1≥3.

12. Système générateur de lumière (1000) selon l'une quelconque des revendications précédentes, comprenant un dispositif de puce sur carte (1100), dans lequel le dispositif de puce sur carte (1100) comprend le premier dispositif générateur de lumière (110), le deuxième dispositif générateur de lumière (120), le troisième dispositif générateur de lumière (130) et le matériau luminescent (200).

13. Système générateur de lumière (1000) selon l'une quelconque des revendications précédentes, comprenant un filament à DEL, dans lequel le filament à DEL comprend le premier dispositif générateur de lumière (110), le deuxième dispositif générateur de lumière (120), le troisième dispositif générateur de lumière (130) et le matériau luminescent (200).

14. Système générateur de lumière (1000) selon l'une quelconque des revendications précédentes, dans lequel la lumière de système (1001) dans le premier mode fonctionnel a une première température de couleur corrélée CCT1, dans lequel la lumière de système (1001) dans le second mode fonctionnel a une seconde température de couleur corrélée CCT2, dans lequel |CCT1-CCT2|≤ 300 K ; et dans lequel la lumière de système (1001) dans le premier mode fonctionnel et dans le second mode fonctionnel a un indice de restitution de couleurs d'au moins 80.

15. Dispositif d'éclairage (1200) sélectionné dans le groupe d'une lampe (1), d'un luminaire (2), d'un dispositif projecteur (3), d'un dispositif de désinfection, d'un réacteur photochimique, d'un dispositif d'éclairage automobile et d'un dispositif de communication optique sans fil, comprenant le système générateur de lumière (1000) selon l'une quelconque des revendications précédentes.
